# EUROPEAN PATENT SPECIFICATION

(11) **EP 4 224 698 B1**
(45) Date of publication and mention of the grant of the patent: **22.04.2026**
(21) Application number: 21886370.2
(22) Date of filing: 29.10.2021
(51) Int. Cl.: H02N 2/04, H02N 2/00, H02N 2/02, H02N 2/10

(54) **VIBRATION-TYPE ACTUATOR CAPABLE OF REDUCING VARIATION IN FORCE GENERATED BETWEEN CONTACT BODY AND VIBRATION BODY, MULTIAXIAL STAGE, MULTI-JOINT ROBOT, AND DEVICE**
VIBRATIONSAKTUATOR ZUR REDUZIERUNG DER KRAFTÄNDERUNG ZWISCHEN KONTAKTKÖRPER UND VIBRATIONSKÖRPER, MEHRACHSIGER MEHRSTUFIGER MEHRGELENKROBOTER UND VORRICHTUNG
ACTIONNEUR DE TYPE À VIBRATION POUVANT RÉDUIRE LA VARIATION DE FORCE GÉNÉRÉE ENTRE UN CORPS DE CONTACT ET UN CORPS DE VIBRATION, ÉTAGE MULTIAXIAL, ROBOT À ARTICULATIONS MULTIPLES ET DISPOSITIF

(30) Priority: 02.11.2020 JP 2020183713
(43) Date of publication of application: 09.08.2023
(73) Proprietor: CANON KABUSHIKI KAISHA, Tokyo 146-8501 (JP)
(72) Inventor: ARIMITSU, Yasumichi, Tokyo 146-8501 (JP)
(74) Representative: WESER & Kollegen Patentanwälte PartmbB
(86) International application number: PCT/JP2021/039980
(87) International publication number: WO 2022/092253

(56) References cited:
- CN-U- 211 127 621
- JP-A- 2005 168 075
- JP-A- 2005 261 167
- JP-A- 2013 230 018
- JP-A- 2014 072 986
- JP-A- 2016 226 129
- JP-A- 2017 200 374
- JP-A- 2019 187 093
- JP-A- 2019 198 227
- JP-A- 2020 058 174
- JP-A- H07 319 543
- JP-B2- 4 341 227
- US-A1- 2013 278 112
- US-A1- 2020 052 614

## Description

### Technical Field

The present invention relates to a vibration type actuator capable of reducing a change in force generated between a contact body and a vibrating body, and a multi-axis stage, an articulated robot and a device that include the vibration type actuator.

### Background Art

A vibration type actuator is known, which generates vibration in combination of different vibration modes in a vibrating body to generate thrust between the vibrating body and a contact body in contact with the vibrating body. In addition, a vibration type actuator is known, which generates a single vibration mode in a vibrating body to change a frictional force between the vibrating body and a contact body. For these vibration type actuators, a configuration in which a plurality of vibrating bodies is provided has been proposed in order to increase thrust and torque, improve a degree of freedom in design, disperse a failure risk, and the like. For example, PTL 1 discloses a configuration in which a plurality of vibrating bodies (piezoelectric vibrating bodies) is arranged in series and a common contact body (moving body) is moved in a predetermined direction.

### Citation List

### Patent Literature

PTL 1: Japanese Laid-Open Patent Publication (kokai) No. S63-316675

### Summary of Invention

### Technical Problem

In a vibration type actuator including a plurality of vibrating bodies as in the technique described in PTL 1, a size of a contact body in a longitudinal direction (movement direction) increases in accordance with the configuration of the vibrating bodies. Therefore, it may not easy to mold (manufacture) the contact body with high accuracy, and it may not be easy to maintain the shape of the contact body with high accuracy in the longitudinal direction (that is, to suppress deformation in the longitudinal direction) over time.

In a case where the shape accuracy of the contact body is not high or in a case where the deformation occurs in the contact body, a pressurizing force generated between the vibrating body and the contact body and a reaction force thereof vary for each of the plurality of vibrating bodies, and as a result, the following problems occur. For example, in a case where the shape accuracy of the contact body is not high, thrust applied to the contact body varies for each vibrating body, and thus, there is a possibility that desired drive characteristics cannot be obtained. In addition, when the pressurizing force and the reaction force decrease due to the deformation of the contact body, a frictional force generated between the vibrating body and the contact body decreases, so that the thrust and the torque decreases. Meanwhile, when the pressurizing force and the reaction force increase due to the deformation of the contact body, deformation and/or damage occurs in the vibrating body and various components holding the vibrating body, and abrasion of the vibrating body or the contact body rapidly progresses due to the increase in the frictional force generated between the vibrating body and the contact body, and a device life may be shortened.

It should be noted that, even in a case of a vibration type actuator including only one vibrating body, a similar problem may occur. That is, in a case where the contact body has a shape that is long only in one direction that is a relative movement direction, the magnitude of the pressurizing force and the reaction force acting between the vibrating body and the contact body may change, due to the shape of the contact body, along with the relative movement between the contact body and the vibrating body.
JP 4 341227 B2 and JP 2005 168075 A disclose further vibration type actuators. They do not have a connection portion with rotational degree of freedom with respect to the vibrating body unit.

The present invention provides a vibration type actuator capable of reducing a change in a pressurizing force and a reaction force which are generated between a contact body and a vibrating body along with relative movement between the contact body and the vibrating body, a multi-axis stage, an articulated robot and a device.

### Solution to Problem

According to an aspect of the present invention, there is provided a vibration type actuator as defined in claim 1. The other claims relate to further developments.

### Advantageous Effects of Invention

According to the present invention, it is possible to provide a vibration type actuator capable of reducing a change in a pressurizing force and a reaction force which are generated between a contact body and a vibrating body along with relative movement between the contact body and the vibrating body.

### Brief Description of Drawings

FIG. 1A is a view showing a schematic configuration of a vibrating body.
FIG. 1B is a view showing the schematic configuration of the vibrating body.
FIG. 1C is a view showing the schematic configuration of the vibrating body.
FIG. 1D is a view showing a schematic structure of a protrusion in the vibrating body in FIGS. 1A to 1C.
FIG. 2A is a schematic view for describing a vibration mode excited in the vibrating body.
FIG. 2B is a schematic view for describing a vibration mode excited in the vibrating body.
FIG. 3 is a front view showing a schematic configuration of a vibration type actuator according to a first embodiment.
FIG. 4A is a partial front view of two vibrating body units.
FIG. 4B is a bottom view corresponding to FIG. 4A.
FIG. 4C is a perspective view showing a nonwoven fabric and a spacer in the vibrating body unit of FIGS. 4A and 4B.
FIG. 5A is a view for describing a configuration of a connecting portion that connects the vibrating body units.
FIG. 5B is a view for describing a variation of the connecting portion in FIG. 5A.
FIG. 5C is a view for describing a variation of the connecting portion in FIG. 5A.
FIG. 6A is a view for describing a configuration of a holding portion for connecting the vibrating body units.
FIG. 6B is a view for describing a variation of the holding portion in FIG. 6A.
FIG. 7 is a view for describing the behavior of the vibration type actuator in which distortion occurs in the contact body.
FIG. 8 is a front view showing a schematic configuration of a vibration type actuator according to a second embodiment.
FIG. 9A is a view for describing an example of a configuration that functions as both a reaction force receiving portion and a contact body support portion in the vibration type actuator.
FIG. 9B is a view for describing an example of a configuration that functions as both the reaction force receiving portion and the contact body support portion in the vibration type actuator.
FIG. 9C is a view for describing an example of a configuration that functions as both the reaction force receiving portion and the contact body support portion in the vibration type actuator.
FIG. 9D is a view for describing an example of a configuration that functions as both the reaction force receiving portion and the contact body support portion in the vibration type actuator.
FIG. 10A is a front view showing a schematic configuration of a vibration type actuator according to a third embodiment.
FIG. 10B is a perspective view showing a schematic configuration of the spacer.
FIG. 11 is a perspective view showing a schematic configuration of a displacement suppressing portion of the vibration type actuator.
FIG. 12 is a front view showing a schematic configuration of a vibration type actuator according to a fourth embodiment.
FIG. 13 is a front view showing a schematic configuration of a vibration type actuator according to a fifth embodiment.
FIG. 14 is a front view showing a schematic configuration of a vibration type actuator according to a sixth embodiment.
FIG. 15A is a plan view showing a schematic configuration of a vibration type actuator according to a seventh embodiment.
FIG. 15B is a front view showing a schematic configuration of the vibration type actuator in FIG. 15A.
FIG. 16 is a front view showing a schematic configuration of a vibration type actuator according to an eighth embodiment.
FIG. 17 is a front view showing a schematic configuration of a vibration type actuator according to a ninth embodiment.
FIG. 18A is a schematic view for describing a structure for supporting a contact body by a plurality of vibrating bodies.
FIG. 18B is a schematic view for describing a structure for supporting the contact body by the plurality of vibrating bodies.
FIG. 18C is a schematic view for describing a structure for supporting the contact body by the plurality of vibrating bodies.
FIG. 18D is a schematic view for describing a structure for supporting the contact body by the plurality of vibrating bodies.
FIG. 18E is a schematic view for describing a structure for supporting the contact body by the plurality of vibrating bodies.
FIG. 18F is a schematic view for describing a structure for supporting the contact body by the plurality of vibrating bodies.
FIG. 19 is a view for describing an example of a configuration in which a displacement detection unit is provided in a vibrating body unit.
FIG. 20A is a view for describing a schematic configuration of an actuator unit according to a tenth embodiment.
FIG. 20B is a view for describing the schematic configuration of the actuator unit of FIG. 20A.
FIG. 20C is a view for describing the schematic configuration of the actuator unit of FIG. 20A.
FIG. 20D is a view for describing the schematic configuration of the actuator unit of FIG. 20A.
FIG. 21A is a view for describing a schematic configuration of an actuator unit according to an eleventh embodiment.
FIG. 21B is a view for describing the schematic configuration of the actuator unit of FIG. 21A.
FIG. 21C is a view for describing the schematic configuration of the actuator unit of FIG. 21A.
FIG. 21D is a view for describing the schematic configuration of the actuator unit of FIG. 21A.
FIG. 22 is a plan view showing a schematic configuration of a device according to a twelfth embodiment.
FIG. 23A is a plan view showing a schematic configuration of a device according to a thirteenth embodiment.
FIG. 23B is a side view showing a schematic configuration of a vibration type actuator constituting the device in FIG. 23A.
FIG. 24 is a plan view showing a schematic configuration of a multi-axis stage according to a fourteenth embodiment.
FIG. 25 is a plan view showing a schematic configuration of an articulated robot according to a fifteenth embodiment.
FIG. 26 is a plan view showing a schematic configuration of an articulated robot according to a sixteenth embodiment.
FIG. 27 is a perspective view showing a schematic configuration of a wire drive manipulator constituting the articulated robot in FIG. 26.

### Description of Embodiments

Hereinafter, embodiments of the present invention will be described in detail with reference to the accompanying drawings.

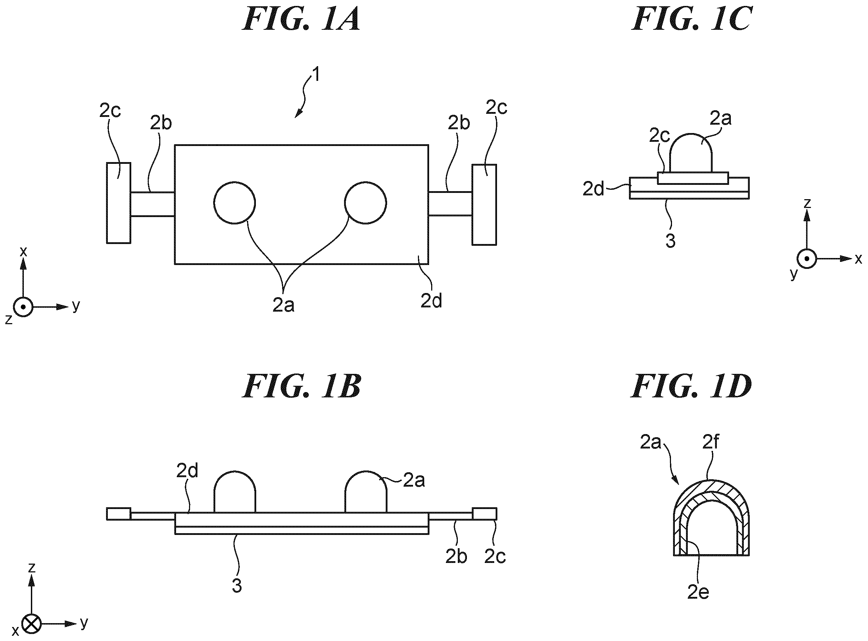

First, a vibrating body and a contact body that are commonly used in a vibration type actuator according to each embodiment described later will be described. FIG. 1A is a plan view showing a schematic configuration of a vibrating body 1 constituting a vibration type actuator, FIG. 1B is a front view of the vibrating body 1, and FIG. 1C is a side view of the vibrating body 1.

It should be noted that, for convenience of description, as shown in FIGS. 1A to 1C, an orthogonal coordinate system including an x axis (x direction), a y axis (y direction), and a z axis (z direction) is set for the vibrating body 1. The z direction is a thickness direction of the vibrating body 1, and is a protruding direction of each of protrusions 2a (details will be described later) provided at two locations. The y direction is a longitudinal direction of the vibrating body 1, and is a direction connecting the two protrusions 2a. The x direction is a lateral direction (width direction) of the vibrating body 1, and is a direction orthogonal to the y direction and the z direction. In each of the directions shown in FIGS. 1A to 1C, a direction from a start point to an end point of an arrow indicating each direction is defined as a positive direction (+ direction), and a direction from the end point to the start point is defined as a negative direction (- direction).

The vibrating body 1 includes an elastic body 2 having elasticity and an electromechanical energy conversion element 3 joined to the elastic body 2. The electromechanical energy conversion element 3 is, for example, a piezoelectric element that converts a voltage into a force by an inverse piezoelectric effect, and is configured by providing electrodes to which a predetermined voltage is applied on front and back surfaces of a rectangular thin plate-shaped piezoelectric ceramic. The elastic body 2 includes the protrusions 2a, a suspension support portion 2b, a support end portion 2c, and a base portion 2d. The two protrusions 2a are provided so as to protrude in the +z direction on a surface opposite to a surface to which the electromechanical energy conversion element 3 is joined in the base portion 2d having a rectangular flat plate shape. It should be noted that the protrusion 2a may be formed by the elastic body 2 (base portion 2d) being pressed or the like, or may be provided by a protruding member being joined to the base portion 2d by a predetermined method. The support end portion 2c is a rectangular flat plate-shaped portion via which the vibrating body 1 is fixed to a holding portion 8 described later. The suspension support portion 2b is a rectangular flat plate-shaped portion that plays a role of connecting the base portion 2d and the support end portion 2c.

Here, the protrusion 2a will be described in more detail. FIG. 1D is a cross-sectional view showing a schematic structure of the protrusion 2a. A friction material 2f is provided on a surface of a base material 2e of the protrusion 2a. It should be noted that, here, the material of the base material 2e is the same as the material of the base portion 2d (not shown in FIG. 1D). In a case where martensitic stainless steel is used for the base material 2e, an electroless nickel plating film, a chrome plating film, a hardened layer by quenching, a nitride film by ion nitriding treatment, or the like can be used for the friction material 2f. In addition, by using fiber-reinforced engineering plastic such as PEEK-CF30 or hard ceramics for the base material 2e, it is also possible to adopt a configuration in which the base material 2e is also used as the friction material 2f (in this case, there is no distinction between the base material 2e and the friction material 2f).

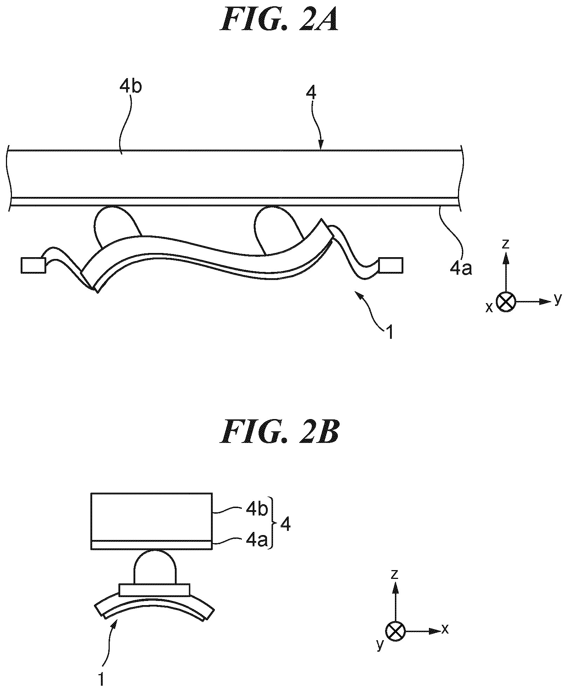

Next, two vibration modes (vibration shapes) excited in the vibrating body 1 will be described. FIG. 2A is a schematic view for describing a first vibration mode excited in vibrating body 1, and FIG. 2B is a schematic view for describing a second vibration mode excited in vibrating body 1. It should be noted that, in FIGS. 2A and 2B, deformation of vibrating body 1 is exaggeratedly illustrated. For convenience of description, a contact body 4 that comes into contact with vibrating body 1 and receives thrust (frictional driving force) from vibrating body 1 is shown in FIGS. 2A and 2B.

The contact body 4 is a member that comes into contact with the vibrating body 1 (protrusion 2a). Due to the vibration generated in the vibrating body 1, the vibrating body 1 and the contact body 4 move relative to each other in the y direction as described later. Contact between the contact body 4 and the vibrating body 1 is not limited to direct contact in which no other member is interposed between the contact body 4 and the vibrating body 1. The contact between the contact body 4 and the vibrating body 1 may be indirect contact in which another member is interposed between the contact body 4 and the vibrating body 1 as long as the vibrating body 1 and the contact body 4 move relative to each other due to vibration generated in the vibrating body 1.

The first vibration mode shown in FIG. 2A is a secondary out-of-plane bending vibration mode in which three nodal lines substantially parallel to the x direction are generated in the base portion 2d. This vibration mode excites vibration that is displaced in the y direction at tips of the two protrusions 2a. Meanwhile, the second vibration mode shown in FIG. 2B is a primary out-of-plane bending vibration mode in which two nodal lines substantially parallel to the y direction are generated in the base portion 2d. This vibration mode excites vibration that is displaced in the z direction at the tips of the two protrusions 2a.

When the vibration in the first vibration mode and the vibration in the second vibration mode are simultaneously excited by applying a plurality of alternating voltages having different phases to the electromechanical energy conversion element 3, an elliptical movement in which both vibrations are combined can be generated in the yz plane at tip portions of the two protrusions 2a. When elliptical movement occurs in the yz plane at the tip portion of the protrusion 2a, the contact body 4 receives thrust in the y direction, and as a result, the contact body 4 and the vibrating body 1 can be moved relative to each other in the y direction.

It should be noted that, in a state where no voltage is applied to the electromechanical energy conversion element 3, a static frictional force between the protrusion 2a and the contact body 4 acts as a holding force for maintaining the relative position between the vibrating body 1 and the contact body 4. In addition, by the voltage applied to the electromechanical energy conversion element 3 being adjusted to adjust an amplitude of vibration to be excited in the vibrating body 1, a contact time between the protrusion 2a and the contact body 4 can be adjusted to change the apparent frictional force. Furthermore, by only the vibration in the second vibration mode in the vibrating body 1 being excited and the vibration amplitude controlled, the frictional force generated between the protrusion 2a and the contact body 4 can be changed. By using these, for example, in the case of a configuration in which the contact body 4 moves with respect to the vibrating body 1, it is possible to adjust the magnitude of the reaction force when an external force (force from other than the vibrating body 1) is applied to the contact body 4 to move the contact body 4. For example, it is possible to adjust an operation reaction force received by a user when the user directly applies an external force to the contact body 4 to operate the contact body 4.

In the vibration type actuator using the vibrating body 1, as shown in FIGS. 2A and 2B, the tip portion of the protrusion 2a comes into contact with the contact body 4 (details will be described later). A friction material 4a is provided on a surface (friction sliding surface) of the contact body 4 in contact with the protrusion 2a. As described above, the friction material 2f is provided on the surface of the protrusion 2a. As a result, stable frictional sliding characteristics can be obtained between the elastic body 2 and the contact body 4. It should be noted that the material and forming method of the friction material 4a are in accordance with the material and forming method of the friction material 2f.

Next, materials used for the vibrating body 1 and the contact body 4 will be described. For the elastic body 2, a high-toughness ceramic such as martensitic stainless steel or partially stabilized zirconia (PSZ) having a small vibration loss is used. In addition, engineering plastics (FRP) such as polyether ether ketone reinforced with about 30 wt% carbon fibers (PEEK-CF30), semiconductors such as silicon carbide (SiC), aluminum alloys, and the like are used for the elastic body 2. A piezoelectric ceramic such as lead titanate-lead zirconate (PZT) is used for the electromechanical energy conversion element 3. For the contact body 4, martensitic stainless steel, an aluminum alloy, FRP such as PEEK-CF30, fine ceramics such as PSZ or alumina (aluminum oxide), or the like is used. It should be noted that the materials to be used for the vibrating body 1 and the contact body 4 are not limited to those described herein.

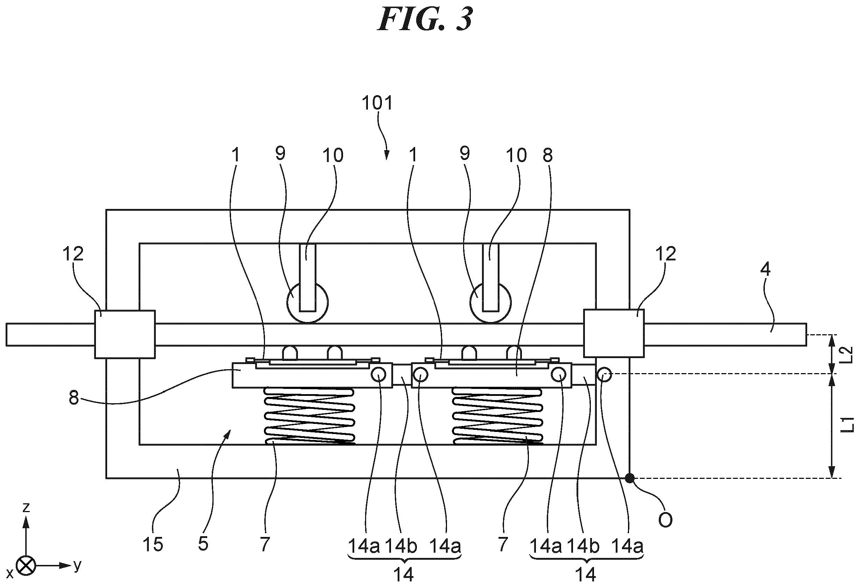

FIG. 3 is a front view showing a schematic configuration of a vibration type actuator 101 according to a first embodiment. The vibration type actuator 101 includes two vibrating body units 5 arranged in series in the y direction, and the contact body 4 in contact with the vibrating body 1 of each of the two vibrating body units 5. It should be noted that an x direction, a y direction, and a z direction of the vibration type actuator 101 are set as shown in FIG. 3 according to the x direction, the y direction, and the z direction set for the vibrating body 1 in FIGS. 1A to 2B. In addition, including vibration type actuators according to another embodiment described below, the y direction is defined as a left-right direction of the vibration type actuator, a +y side is defined as the right side, and a -y side is defined as the left side. In addition, the z direction is defined as an up-down direction of the vibration type actuator, a +z side is defined as the upper side, and a -z side is defined as the lower side.

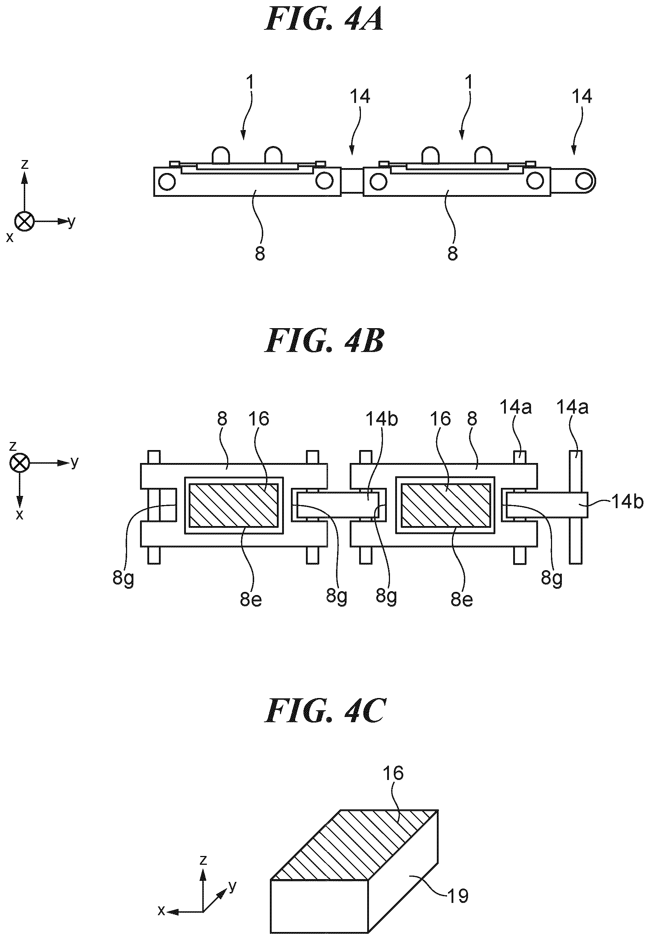

The vibrating body unit 5 includes the vibrating body 1, a nonwoven fabric 16, a pressurizing unit 7, the holding portion 8, a reaction force receiving portion 9, and a rotation support portion 10. The vibrating body unit 5 has a pressurizing support structure capable of exciting vibrations in the vibration modes shown in FIGS. 2A and 2B. In one vibrating body unit 5, the support end portion 2c (of the elastic body 2) of the vibrating body 1 is fixed to an upper surface of a wall portion on the y direction side which is a side wall of the holding portion 8. The nonwoven fabric 16 is disposed on a back surface side (a surface side opposite to a surface joined to the elastic body 2) of the electromechanical energy conversion element 3. The nonwoven fabric 16 is a fabric-shaped member made of a nonwoven fabric material such as wool felt or glass wool, and supports vibrating body 1 while maintaining a vibration mode generated in vibrating body 1. When the pressurizing unit 7 presses the vibrating body 1 toward the contact body 4 via the nonwoven fabric 16 and a spacer 19 described later with reference to FIG. 4C, the protrusion 2a of the vibrating body 1 comes into contact with the contact body 4. It should be noted that since the vibrating body 1 is fixed to the holding portion 8, holding portion 8 is integrated with the vibrating body 1 and pressed toward the contact body 4.

Here, a method of installing the nonwoven fabric 16 will be described. FIG. 4A is a partial front view of the two vibrating body units 5, and FIG. 4B is a bottom view corresponding to FIG. 4A. The holding portion 8 is provided with a through hole 8e penetrating in the z direction. When the holding portion 8 is viewed from the -z direction side in a state where the vibrating body 1 is held by the holding portion 8, the electromechanical energy conversion element 3 is exposed from the through hole 8e. The nonwoven fabric 16 (hatched region in FIG. 4B) is installed inside the through hole 8e so as to be in contact with the electromechanical energy conversion element 3.

It should be noted that although it is not shown, a flexible wiring board for supplying power to the electromechanical energy conversion element 3 is actually attached to the back surface (the surface on the -z direction side) of the electromechanical energy conversion element 3. Therefore, precisely, the nonwoven fabric 16 is installed so as to be in contact with the flexible wiring board attached to the electromechanical energy conversion element 3.

FIG. 4C is a perspective view showing, together with the nonwoven fabric 16, a schematic configuration of the spacer 19 disposed on the -z direction side of the nonwoven fabric 16. It should be noted that the spacer 19 is not shown in FIGS. 1A to 3 since the spacer 19 is hidden by the holding portion 8. The spacer 19 has a substantially rectangular parallelepiped shape, and is fitted into the through hole 8e, in a state where the nonwoven fabric 16 is attached to, so as to be displaceable in the z direction.

The pressurizing unit 7 brings the nonwoven fabric 16 into pressure contact with the electromechanical energy conversion element 3 via the spacer 19, whereby the protrusion 2a of the vibrating body 1 is pressed against the contact body 4 with a predetermined pressurizing force. The pressurizing unit 7 is constituted by, for example, a component having an elastic force such as a coil spring, a leaf spring, a disc spring, a wave washer, rubber, or an air tube exhibiting a restoring force in the z direction. FIG. 3 shows an example in which a compression coil spring is used for the pressurizing unit 7.

The reaction force receiving portion 9 is disposed so as to be in contact with the upper surface (+z side) of the contact body 4 (with the surface, of contact body 4, opposite to contact surface with protrusion 2a), and receives a reaction force of a force pressing the vibrating body 1 (protrusion 2a) against the contact body 4. In the vibration type actuator 101, the reaction force receiving portion 9 is a roller supported by the rotation support portion 10 attached to a support member 15 so as to be rotatable about an axis parallel to the x axis. The support member 15 is a base material for assembling various components constituting the vibration type actuator 101. In the vibration type actuator 101 mounted on a device, the support member 15 is fixed to a frame or the like of the device, and the contact body 4 moves in the y direction with respect to the support member 15 (vibrating body unit 5) whose position does not change in the device.

The contact body 4 is supported by the support member 15 in a state of being movable in the y direction by the thrust received from the vibrating body 1 provided in each of the two vibrating body units 5. Specifically, four rollers that are rotatable about an axis parallel to the z axis are provided on the support member 15, as contact body support portions 12 that movably support the contact body 4. The four contact body support portions 12 play a role of a linear guide that enables movement of the contact body 4 in the y direction in a state where a degree of freedom of the contact body 4 in the x direction is restricted.

In the vibrating body unit 5 located on the right side (+y side) out of the two vibrating body units 5, the holding portion 8 is attached to the support member 15 by a connecting portion 14. The holding portion 8 of the left vibrating body unit 5, out of the two vibrating body units 5, is connected to the holding portion 8 of the right vibrating body unit 5 by the connecting portion 14.

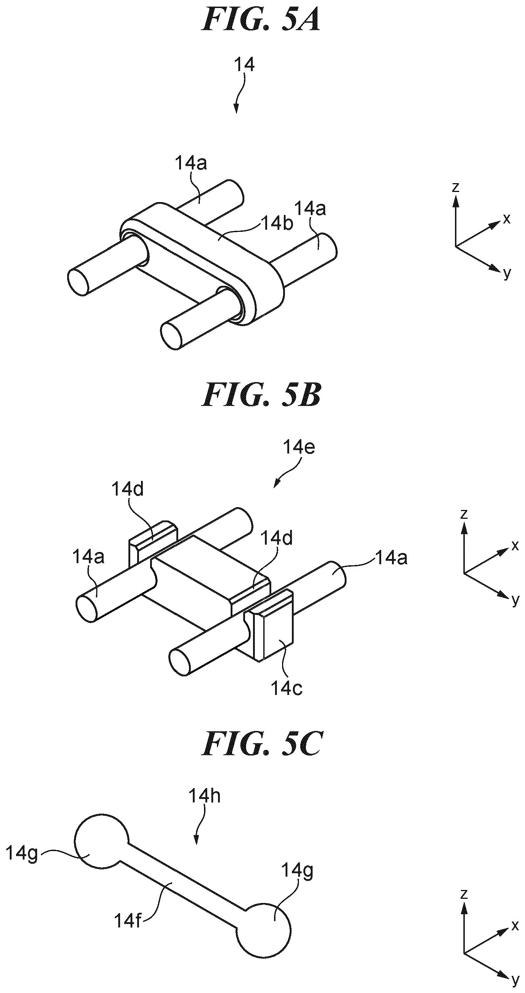

FIG. 5A is a perspective view showing a schematic configuration of the connecting portion 14. The connecting portion 14 includes a link member 14b (coupling portion) provided with two holes at predetermined intervals so as to penetrate in the x direction, and a cylindrical columnar pin 14a (shaft portion) inserted into each of the two holes of the link member 14b and attached to the link member 14b substantially in parallel. The two pins 14a are fixed to the link member 14b in the respective holes of the link member 14b. It should be noted that the two pins 14a and the link member 14b may be integrally (seamlessly) formed in an H shape when viewed from the z direction.

One of the two pins 14a is positioned at a position away from a reference origin O of the support member 15 shown in FIG. 3 in the +z direction by a distance L1, whereby the connecting portion 14 has a rotational degree of freedom about the central axis of the pin 14a positioned in the support member 15. Meanwhile, the center of the contact body 4 is positioned at a position away from the center of the pin 14a positioned in the support member 15 by a distance L2 in the +z direction. Thus, the contact body 4 is accurately positioned at a position away from the reference origin O of the support member 15 by a distance L1 +L2 in the +z direction.

Here, a variation of the connecting portion 14 will be described. FIG. 5B is a perspective view showing a schematic configuration of a connecting portion 14e which is a first variation of the connecting portion 14. The connecting portion 14e includes a link member 14c and two pins 14a. The pins 14a are the same as ones described with reference to Figure 5A. The link member 14c is provided with two holes penetrating in the x direction, and an openings 14d are provided on the +z side so as to open a part of respective holes. A snap-fit structure is applied, in which the pin 14a is not inserted into the hole from the x direction but pressed into the hole from the +z side through the opening 14d to be fitted, and thus, the connecting portion 14e can be easily assembled.

FIG. 5C is a perspective view showing a schematic configuration of a connecting portion 14h which is a second variation of the connecting portion 14. The connecting portion 14h is a ball joint in which spherical portions 14g are provided at both ends of a cylindrical columnar link member 14f (shaft portion). When the support member 15 and the holding portion 8 are connected by the connecting portion 14h, one spherical portion 14g is movably arranged on the holding portion 8, and the other spherical portion 14g is movably arranged on the support member 15.

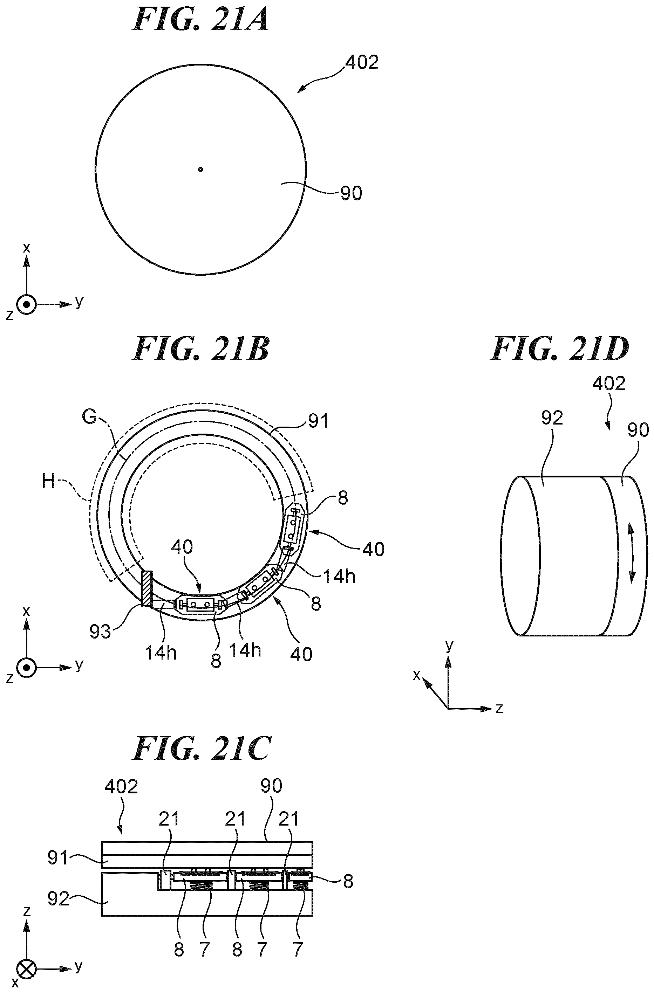

The rotational degrees of freedom of the connecting portion 14, 14e, and 14h will be described. The connecting portion used in the vibration type actuator according to the present invention may be any as long as it has a rotation shaft having a rotational degree of freedom of two or more degrees of freedom and is restricted by the vibrating body unit by a rotation shaft having a rotational degree of freedom of one or more degrees of freedom. The connecting portion 14, 14e has two degrees of freedom about the axes of the two pins 14a. In other words, the connecting portion 14, 14e is restricted by the pins 14a which have one degree of freedom with respect to the support member 15 and the vibrating body unit 5. Meanwhile, the connecting portion 14h has two degrees of freedom for one spherical portion 14g. In other words, the connecting portion 14h is restricted by the spherical portion 14g which has two rotational degrees of freedom with respect to the support member 15 and the vibrating body unit 5. Further, the connecting portion 14h has one degree of freedom about an axis parallel to the y axis of the link member 14f. That is, the connecting portion 14h has a total of five degrees of freedom. Therefore, in the case of using the connecting portion 14h, as compared with the case of using the connecting portion 14, 14e, it is possible to cause the vibrating body unit 5 to follow a complicated shape including twisting or the like of the contact body 4 in a predetermined direction and to arrange the vibrating body unit 5 along the curved surface. As a specific configuration in which the vibrating body unit 5 is arranged along the curved surface, a configuration in which the vibrating body unit 5 is arranged circumferentially will be described later with reference to FIGS. 21A to 21D.

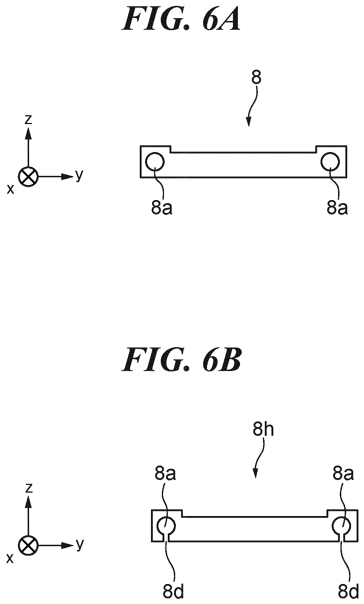

Next, a configuration of the holding portion 8 for connecting the plurality of vibrating body units 5 using the connecting portion 14 and the like will be described. FIG. 6A is a front view showing a schematic configuration of the holding portion 8. Cylindrical clearance holes 8a into which the pins 14a are inserted and fitted, and concave portions 8g (see FIG. 4B) in which the link members 14b of the connecting portion 14 are disposed are provided at left and right ends (both ends in the y direction) of the holding portion 8, respectively. An appropriate gap is provided between the link member 14b and the concave portion 8g. The pin 14a is inserted and fitted into the clearance hole 8a without rattling as much as possible, whereby the holding portions 8 are connected by the connecting portion 14. In this state, the holding portion 8 and the connecting portion 14 have a degree of freedom so as to relatively rotate about the central axis of the pin 14a. That is, the two vibrating body units 5 can be displaced in the z direction and can be inclined around an axis parallel to the x axis by having two degrees of freedom of rotation around an axis parallel to the x axis at the connecting portion 14.

FIG. 6B is a front view showing a schematic configuration of a holding portion 8h according to a variation of the holding portion 8. The holding portion 8h is provided with an opening 8d on the -z side of the clearance hole 8a. The holding portion 8h has a snap-fit structure in which the pin 14a is pushed and fitted into the clearance hole 8a from the -z side through the opening 8d instead of being inserted and fitted into the clearance hole 8a from the x direction. In this case, the connecting portion 14 in a state where the pin 14a is fixed to the link member 14b in advance can be easily assembled to the holding portion 8h from the -z side, and thus productivity can be improved.

In the vibration type actuator 101 configured as described above, the generated thrust and torque are increased by providing the two vibrating body units 5. A length of the contact body 4 in the y direction, which is the movement direction, is larger than a thickness (length in the z direction) and a width (length in the x direction) of the contact body 4. In this case, the contact body 4 is likely to be deflected or twisted in the y direction due to processing, residual stress of a material to be used, or the like, and thus, it is not easy to improve the shape accuracy of the contact body 4. This problem is more remarkable when the thickness of the contact body 4 is reduced in order to reduce the size of the vibration type actuator 101. Even when the contact body 4 can be processed with high shape accuracy, it is easily assumed that deflection, twisting, or the like occurs in the contact body 4 in the longitudinal direction due to heat treatment such as quenching, ion nitriding, or annealing being performed thereafter or due to a change with time.

In a case where the original shape accuracy of the contact body 4 is not high or in a case where a deformation is occurred in the contact body 4, the relative position between the contact body 4 and the vibrating body unit 5 changes in the z direction which is the pressurizing direction of the vibrating body unit 5 with respect to the contact body 4. For this reason, there is a difference in the pressurizing force for pressing the vibrating body 1 against the contact body 4 for each of the plurality of vibrating body units 5. Such a change in the pressurizing force is assumed to be caused by movement of the contact body 4 in the y direction. For example, in the case of the vibrating body 1 in which the pressurizing force is smaller than an ideal state (design value), the frictional force generated between the vibrating body 1 and the contact body 4 decreases, and thus, there is a possibility that the thrust or torque to be generated decreases. Meanwhile, in the case of the vibrating body 1 in which the pressurizing force is larger than that in the ideal state, a surface pressure of the contact surface between the vibrating body 1 and the contact body 4 becomes excessive, which may cause abnormal wear. **In** addition, the reaction force received from the contact body 4 when the vibrating body 1 is driven increases, which may cause deformation or breakage of the suspension support portion 2b of the vibrating body 1.

**In** order to avoid the occurrence of such a problem, in the vibration type actuator 101, the vibrating body units 5 are independently supported to be displaceable in the z direction. Hereinafter, this characteristic configuration will be described in detail.

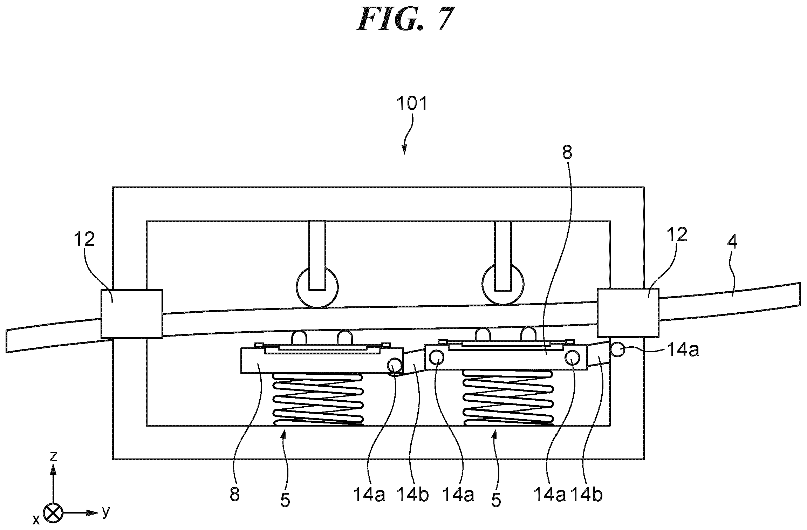

FIG. 7 is a front view for describing a behavior of the vibration type actuator 101 when distortion occurs in the contact body 4 in a plane parallel to the yz plane. It should be noted that deformation (distortion) of the contact body 4 is exaggeratedly illustrated in FIG. 7, in order to facilitate understanding of the movement of the vibrating body unit 5.

In the vibration type actuator 101, each of the two vibrating body units 5 can be displaced in the z direction following the distortion of the contact body 4 via the connecting portion 14. As a result, it is possible to reduce a change in the pressurizing force of each of the two vibrating bodies 1 to the contact body 4 and a change in reaction force of said each pressurizing force. That is, even when the contact body 4 is deflected, twisted, or the like in the y direction, the vibrating body unit 5 is displaced in the z direction in a driven manner. Therefore, by using the two vibrating body units 5, the magnitude of the pressurizing force of the vibrating body 1 with respect to the contact body 4 and the magnitude of the reaction force received by the reaction force receiving portion 9 can be constantly maintained. As a result, the two vibrating body units 5 can efficiently generate thrust (for example, a design value of thrust) of an appropriate magnitude with respect to the contact body 4. In addition, the two vibrating body units 5 can suppress occurrence of insufficient thrust due to insufficient pressurizing force and occurrence of wear and damage due to excessive pressurizing force.

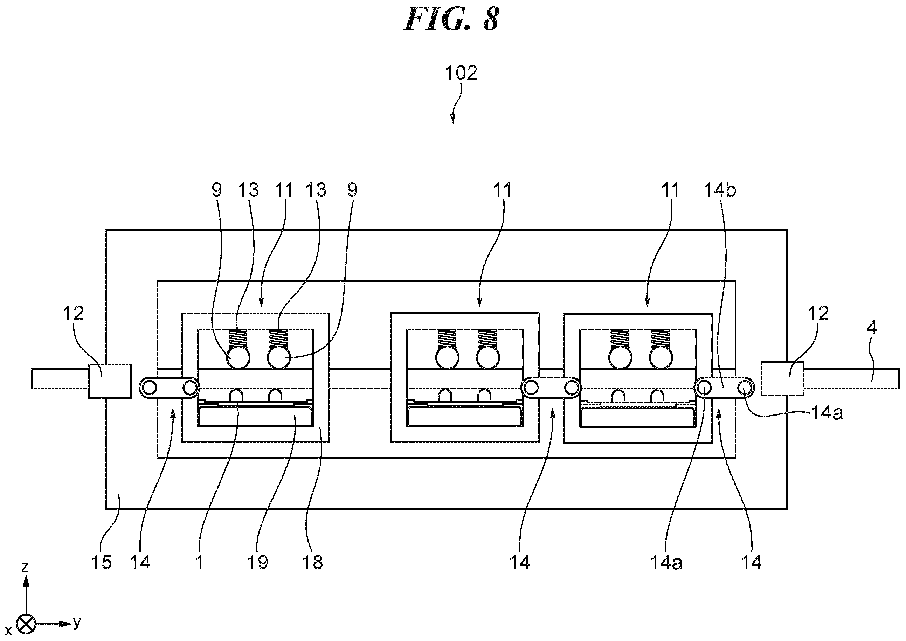

FIG. 8 is a front view showing a schematic configuration of a vibration type actuator 102 according to a second embodiment. An orthogonal coordinate system (shown) set for the vibration type actuator 102 conforms to that of the first embodiment. Similarly, an orthogonal coordinate system is set for the vibration type actuator and the actuator unit according to each embodiment described below. In addition, among the components of the vibration type actuator 102, components corresponding to the components of the vibration type actuator 101 (see FIG. 3) will be described using the same names and reference numerals, and description of common functions and configurations will be omitted.

The vibration type actuator 102 includes three vibrating body units 11. The vibrating body unit 11 includes a holding portion 18. The holding portion 18 corresponds to a configuration in which the holding portion 8, the pressurizing unit 7, the reaction force receiving portion 9, and the rotation support portion 10 constituting the vibrating body unit 5 used in the vibration type actuator 101 are integrally unitized. In the vibrating body unit 11, the spacer 19 to which the nonwoven fabric 16 is attached is disposed inside the holding portion 18. In a state where the nonwoven fabric 16 is in contact with the electromechanical energy conversion element 3 constituting the vibrating body 1, the support end portion 2c at the end of the vibrating body 1 in the y-direction is fixed to the holding portion 18. It should be noted that although the shape (size) of the spacer 19 to which the nonwoven fabric 16 is attached is different between the vibrating body unit 5 and the vibrating body unit 11, the spacer has the configuration shown in FIG. 4C.

The reaction force receiving portion 9 is disposed so as to be in contact with the upper surface (+z side) of the contact body 4 (with the surface, of contact body 4, opposite to contact surface with protrusion 2a), and receives a reaction force of a force pressing the vibrating body 1 (protrusion 2a) against the contact body 4. The reaction force receiving portion 9 is supported rotatably about an axis parallel to the x axis by a rotation support portion 10 (not shown in FIG. 8) equivalent to the rotation support portion 10 of the vibration type actuator 101, and a compression coil spring is disposed as the pressurizing unit 13 with respect to the rotation support portion 10. With this configuration, by the pressure reaction force (force by which the compression coil spring tends to expand in the z direction) of the pressurizing unit 13, the reaction force receiving portion 9 is pressed against the contact body 4 and the tip of the protrusion 2a of the vibrating body 1 is pressed against the contact body 4.

Out of the three vibrating body units 11, the two vibrating body units 11 arranged on the left and right (-y side and +y side) are each connected to the support member 15 via the connecting portion 14, and thus, can be displaced in the z direction, similarly to the vibrating body unit 5 on the right side of the vibration type actuator 101. The center vibrating body unit 11 is connected to the right vibrating body unit 11 via the connecting portion 14, and thus, can be displaced in the z direction, similarly to the left vibrating body unit 5 of the vibration type actuator 101. In the vibration type actuator 102, the left vibrating body unit 11 and the center vibrating body unit 11 are independent without being restricted from each other. The other elements of the vibration type actuator 102 are configured similarly to the vibration type actuator 101, and thus the description thereof will be omitted.

It should be noted that, in the vibration type actuator 102, in a case where interference between the connecting portion 14 and the contact body 4 is concerned, this problem can be solved by the connecting portion 14 being installed offset by a predetermined distance in the x direction. Further, in the vibration type actuator 102, it is desirable that a plurality of (specifically, three) connecting portions 14 is arranged such that the pins 14a are arranged on the same xy plane as the contact surface between the contact body 4 and the protrusion 2a. For example, it is assumed that deformation such as distortion or twisting occurs in the contact body 4 as described in the first embodiment. In this case, when each of the vibrating body units 11 is displaced in the z direction following the shape of the contact body 4, a moment of force in the yz plane due to the thrust generated between the contact body 4 and the protrusion 2a is generated with the pin 14a of the connecting portion 14 as a fulcrum. At this time, with the pin 14a on the same plane as the contact surface between the contact body 4 and the protrusion 2a, the point at which the thrust is generated and the fulcrum at which the rotational movement is generated are in the same plane. Therefore, it is possible to suppress the generation of the bending moment generated in the contact body 4 when the thrust is generated in the vibrating body unit 11. As a result, the three vibrating body units 11 can efficiently generate thrust of an appropriate magnitude with respect to the contact body 4. Further, it is possible to suppress variations and fluctuations in the pressurizing force in frictional sliding portions of the three vibrating body units 11, and thus it is possible to suppress wear and breakage of the contact body 4 due to excessive pressurizing force.

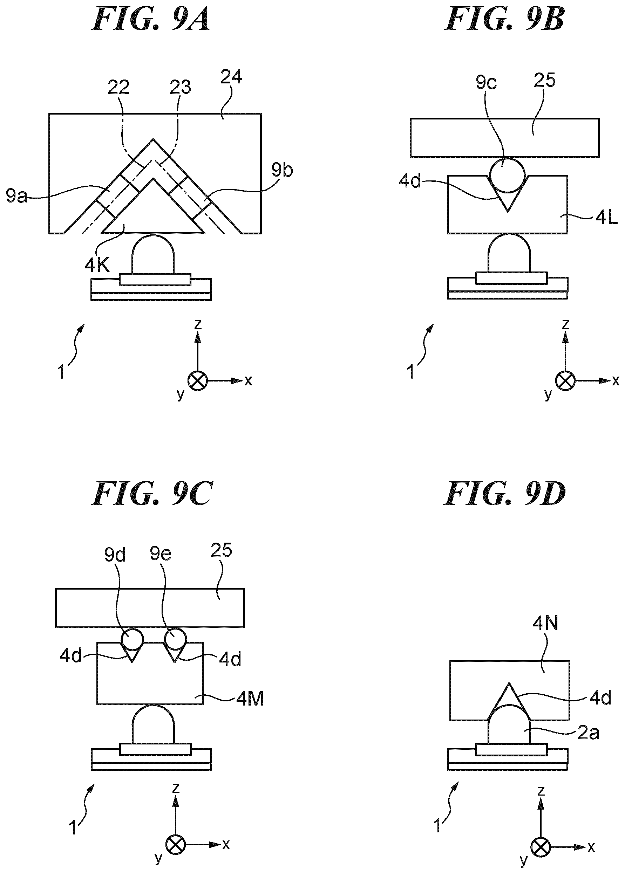

In the above-described configurations of the vibration type actuators 101 and 102, the contact body support portion 12 is provided as a component different from the reaction force receiving portion 9 provided in the vibrating body units 5 and 11. However, the configuration of the vibration type actuator is not limited thereto, and a configuration described below with reference to FIGS. 9A to 9D can also be adopted.

FIGS. 9A to 9D are views for describing an example of a configuration in which the reaction force receiving portion 9 also functions as the contact body support portion 12. FIG. 9A shows a configuration including rollers 9a and 9b each functioning as the reaction force receiving portion and the contact body support portion. The rollers 9a and 9b are provided on a frame 24 having a groove having a V-shaped zx cross section. The contact body 4K having a triangular-shaped zx cross section is pressed upward (+z direction) by the vibrating body 1. The rollers 9a and 9b rotate following the contact body 4K about the rotation shafts 22 and 23, respectively. The rollers 9a and 9b function as the reaction force receiving portion that receives a reaction force against a force for pressurizing the contact body 4K in the z direction, and also function as the contact body support portion that restricts the degree of freedom of the contact body 4K in the x direction.

FIG. 9B shows a configuration including a rolling element 9c functioning as the reaction force receiving portion and the contact body support portion. The spherical rolling element 9c is sandwiched in the z direction by a V-shaped groove 4d provided in a contact body 4L so as to extend in the y direction and the frame 25, and is pressed upward (+z direction) by the vibrating body 1. The rolling element 9c functions as the reaction force receiving portion that receives a reaction force against a force for pressurizing the contact body 4L in the z direction, and also functions as the contact body support portion that restricts the degree of freedom of the contact body 4L in the x direction.

FIG. 9C shows a configuration in which rolling elements 9d and 9e each of which can be used in the configuration of FIG. 9B are disposed in a plurality of (two) V-shaped grooves 4d provided in a contact body 4M, respectively. The rolling elements 9d and 9e function as the reaction force receiving portion and the contact body support portion. As can be seen from the configurations of FIGS. 9B and 9C, the number of grooves provided in the contact body is not limited. For example, the number of grooves may be determined so as to properly match the width (length in the x direction) of the contact body and to stably move the contact body in the y direction, and the rolling elements may be disposed in the grooves respectively.

FIG. 9D shows a configuration in which a V-shaped groove 4d is provided on the frictional sliding surface side of a contact body 4N, and the protrusion 2a is in pressure contact with the slopes of the groove 4d. In this configuration, the protrusion 2a of the vibrating body 1 functions as the reaction force receiving portion and the contact body support portion. By applying the configurations of FIGS. 9A to 9D to the vibration type actuators 101 and 102, the number of components of the vibrating body units 5 and 11 can be reduced, and the configuration can be simplified.

The vibration type actuator 101 including the two vibrating body units 5 and the vibration type actuator 102 including the three vibrating body units 11 have been described above. However, even with the configuration in which one vibrating body unit 5 or 11 is connected to the support member 15 via the connecting portion 14, it is possible to obtain the effect of keeping the change small in the pressurizing force of the vibrating body 1 to the contact body 4 and the reaction force thereof.

Furthermore, the number of vibrating body units included in one vibration type actuator can be appropriately changed according to the length of the contact body, the required thrust, the specifications of the vibration type actuator, and the like. In each of the vibration type actuators 101 and 102, the four contact body support portions 12 are provided on the support member 15, but the number of contact body support portions is not limited thereto, and may be three or more. Furthermore, the contact body support portion is not necessarily provided in the support member 15, and may be provided in a holding portion constituting the vibrating body unit as described later.

In each of the vibration type actuators 101 and 102, a roller that is rotatable around an axis at a predetermined position and is capable of supporting the contact body 4 is used for each of the reaction force receiving portion 9 and the contact body support portion 12. The reaction force receiving portion 9 and the contact body support portion 12 are not limited thereto, and a roller having a movable rotation shaft and having a constant-pressure preload configuration biased to the contact body 4 by an elastic body such as a spring, or any slide guide mechanism capable of supporting the contact body may be used. In addition, the number, shape, and arrangement position of the reaction force receiving portions 9 provided for each of the vibrating body units 5 and 11 can be arbitrarily set, and an arbitrary element that receives a reaction force of the force of the vibrating body 1 pressurizing the contact body 4 can be adopted as the reaction force receiving portion 9.

As the contact body 4, the rod-shaped constituent element extending integrally (structurally without a seam) in the y direction has been described. However, the contact body may alternatively have a laminated structure in which a plurality of materials formed in a strip shape is joined. Further, regarding the relative movement between the vibrating body and the contact body, the configuration in which the contact body moves while the vibrating body unit does not move has been described, but the vibrating body unit may move while the contact body does not move.

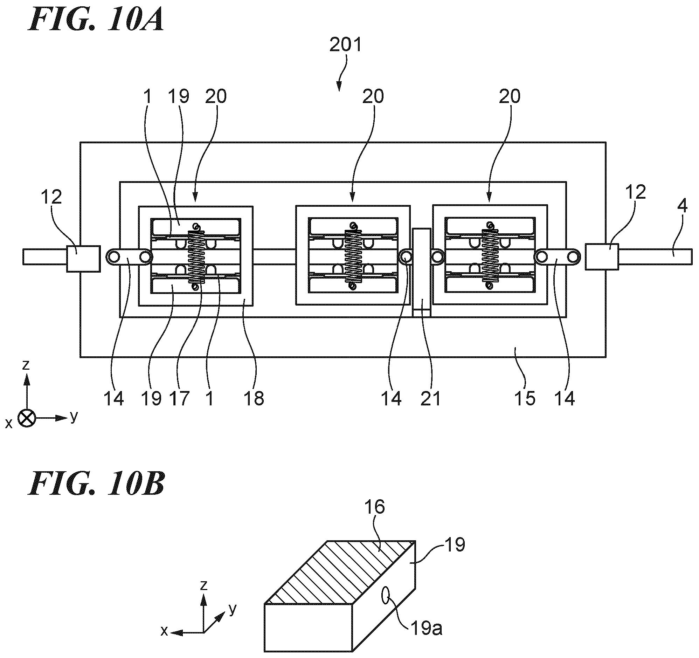

FIG. 10A is a front view showing a schematic configuration of a vibration type actuator 201 according to a third embodiment. Among components of the vibration type actuator 201, components corresponding to the above-described components of each vibration type actuator will be described using the same names and reference numerals, and description of common functions and configurations will be omitted.

The vibration type actuator 201 includes three vibrating body units 20 that are arranged in series in the y direction, which is the movement direction of the contact body 4, and drive the contact body 4 in the y direction. Each of the three vibrating body units 20 includes two vibrating bodies 1 arranged to face each other in the up-down direction (z direction) with the contact body 4 interposed therebetween. The protrusions 2a of each vibrating body 1 are in contact with the contact body 4 with a predetermined pressurizing force. Since upper and lower surfaces (xy surfaces) of the contact body 4 serve as frictional sliding surfaces with the protrusions 2a, it is desirable that friction materials 4a (see FIGS. 2A and 2B) are provided on the upper and lower surfaces of the contact body 4.

As compared with the vibrating body unit 11 of the vibration type actuator 102 (see FIG. 8), the vibrating body unit 20 can be said to have a configuration in which the reaction force receiving portions 9 are replaced with the protrusions 2a of the vibrating body 1. The holding portion 18 is equivalent to the holding portion 18 of the vibrating body unit 11.

FIG. 10B is a perspective view showing a schematic configuration of the spacer 19. Each of the vibrating bodies 1 held by the holding portion 18 is supported by the spacer 19 having an upper surface to which a nonwoven fabric 16 is attached. The spacer 19 is disposed with respect to each vibrating body 1 such that the nonwoven fabric 16 is in contact with the electromechanical energy conversion element 3. A hook 19a for hooking an end portion of a tension coil spring used as the pressurizing unit 17 is provided on a side surface of the spacer 19. In the vibrating body unit 20, the two spacers 19 arranged with the contact body 4 interposed therebetween are attracted to each other by the tension coil spring in the z direction, whereby the two vibrating bodies 1 are attracted to the contact body 4, and the protrusions 2a are in contact with the contact body 4 with a predetermined pressurizing force.

The support member 15 is provided with the contact body support portions 12. A method of guiding the contact body 4 in the y direction by the contact body support portions 12 is the similar to those in the first and second embodiments. Among the three vibrating body units 20, two vibrating body units 20 arranged on the left and right sides (-y side and +y side) are each connected to the support member 15 via the connecting portion 14, similarly to the left and right vibrating body units 11 of the vibration type actuator 102. Among the three vibrating body units 20, the center vibrating body unit 20 is connected to the right vibrating body unit 20 via the connecting portion 14. In this way, each of the three vibrating body units 20 can be displaced in the z direction.

As described in the second embodiment, if there is a concern about interference between the connecting portion 14 and the contact body 4, it is desirable to offset the connecting portion 14 by a predetermined distance in the x direction. It should be noted that, in the vibration type actuator 201, similarly to the vibration type actuator 102, the left vibrating body unit 20 and the center vibrating body unit 20 are independent from each other without being restricted.

In the vibration type actuator 201, the connecting portion 14 is preferably disposed such that the center of the pin 14a is located in a plane (in a plane passing through the center of the contact body 4 in the z direction and parallel to the y axis) including the center point connecting the tips of the protrusions 2a facing each other with the contact body 4 interposed therebetween. This is because, as described in the second embodiment, this makes it possible to suppress the generation of the bending moment generated in the contact body 4 when the thrust is generated in the vibrating body unit 20.

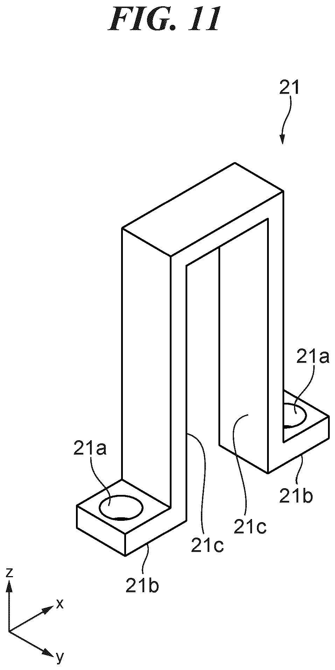

In the vibration type actuator 201, the connecting portion 14 coupling the right vibrating body unit 20 and the center vibrating body unit 20 has a degree of freedom in the x direction restricted by the displacement suppressing portion 21. FIG. 11 is a perspective view showing a schematic configuration of the displacement suppressing portion 21. The displacement suppressing portion 21 has a gate shape, and a bottom surface portion 21b thereof is fixed to the support member 15. As a method of fixing the bottom surface portion 21b to the support member 15, a method using an adhesive or a method using a screw, a rivet, or the like and using a clearance hole 21a provided in the bottom surface portion 21b can be used for the fixing.

The displacement suppressing portion 21 is fixed to the support member 15 such that both side surfaces (side surfaces in the x direction) of the link member 14b of the connecting portion 14 are accommodated between facing inner walls 21c of the displacement suppressing portion 21. At this time, gaps generated between both side surfaces of the link member 14b and the inner walls 21c are desirably as small as possible within a range in which the connecting portion 14 can smoothly move in the z direction.

In the vibration type actuator 201, as compared with the vibration type actuator 102, the reaction force receiving portion 9 is replaced with the protrusion 2a of the vibrating body 1, and the number of protrusions 2a for driving the contact body 4 is increased. Therefore, a larger thrust can be obtained by the vibration type actuator 201. Further, in the vibration type actuator 201, since the protrusion 2a of the vibrating body 1 functions as the reaction force receiving portion 9, a separate component is unnecessary as the reaction force receiving portion 9, and thus, it is possible to realize simplification of the configuration. Further, the side surfaces of the connecting portion 14 attached to the center vibrating body unit 20 among the three vibrating body units 20 is restricted by the displacement suppressing portion 21. As a result, when an external force in the x direction and a moment about an axis parallel to the z axis are applied to the center vibrating body unit 20, it is possible to suppress breakage of a component receiving these forces and moments.

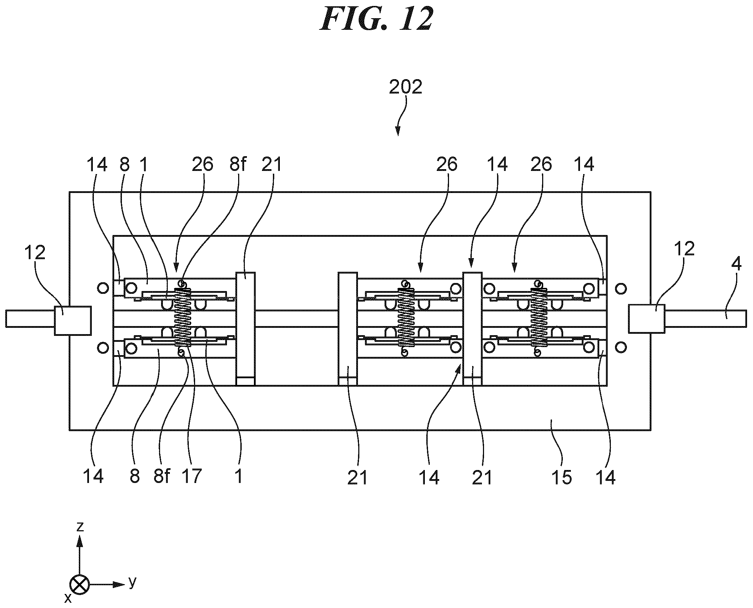

FIG. 12 is a front view showing a schematic configuration of a vibration type actuator 202 according to a fourth embodiment. Among the components of the vibration type actuator 202, components corresponding to the above-described components of each vibration type actuator will be described using the same names and reference numerals, and description of common functions and configurations will be omitted.

The vibration type actuator 202 includes three vibrating body units 26 that are arranged in series in the y direction, which is the movement direction of the contact body 4, and drive the contact body 4 in the y direction. It should be noted that the support member 15 is provided with the contact body support portions 12, and a method of guiding the contact body 4 in the y direction by the contact body support portions 12 is similar to that in the vibration type actuator 101 (see FIG. 3).

Each of the three vibrating body units 20 includes two vibrating bodies 1 arranged to face each other in the z direction with the contact body 4 interposed therebetween. The protrusions 2a of each vibrating body 1 is in contact with the contact body 4 with a predetermined pressurizing force. Each vibrating body 1 is supported by the holding portion 8, and a method of supporting the vibrating body 1 and a method of installing the nonwoven fabric and the spacer are similar to those of the vibration type actuator 102 (see FIG. 8). A hook 8f is provided on a side surface of the holding portion 8. An end portion of a tension coil spring used as the pressurizing unit 17 is hooked on the hook 8f. As a result, in each of the vibrating body units 26, the two vibrating bodies 1 are attracted to the contact body 4 via the holding portions 8, and the protrusions 2a comes into contact with the contact body 4 with a predetermined pressurizing force.

Similarly to the vibration type actuator 101 (FIG. 3), the two holding portions 8 constituting each of the two vibrating body units 26 arranged on the right and left among the three vibrating body units 26 are connected to the support member 15 via the connecting portions 14, and thus, can be displaced in the z direction. The two holding portions 8 constituting the center vibrating body unit 26 and the two holding portions 8 constituting the right vibrating body unit 26 are connected to each other via the connecting portions 14 (according to the configuration shown in FIGS. 4A and 4B,). As a result, the two holding portions 8 constituting the central vibrating body unit 26 can be displaced in the z direction. In the vibration type actuator 202, for example, similarly to the vibration type actuator 102, the left vibrating body unit 26 and the center vibrating body unit 26 are independent from each other without being restricted from each other.

In the vibration type actuator 202, it is desirable that the connecting portions 14 are provided so as to face each other in the z direction such that midpoints of the pins 14a facing each other in the z direction are arranged on a plane including center points connecting the tips of the protrusions 2a facing each other in the z direction (that is, arranged on the center of the contact body 4 in the z direction). In the vibration type actuator 202, the degree of freedom of the holding portions 8 in the x direction is restricted by the displacement suppressing portions 21 provided at three locations. The manner in which the displacement suppressing portion 21 restricts the degree of freedom of the holding portions 8 is similar to the manner in which the displacement suppressing portion 21 restricts the connecting portion 14 in the above-described third embodiment. The inner walls 21c (see FIG. 11) of the right displacement suppressing portion 21 are provided to face the side surfaces of the four holding portions 8 constituting the two vibrating body units 26, and restricts the degree of freedom of the holding portion 8 in the x direction. At this time, gaps generated between the side surfaces of the holding portion 8 in the x direction and the inner walls 21c of the displacement suppressing portion 21 are desirably as small as possible within a range in which the holding portion 8 can move smoothly in the z direction. The method for fixing displacement suppressing portion 21 is as described in the third embodiment.

As described above, the vibration type actuator 202 having a support structure different from that of the vibration type actuator 201 (see FIG. 10A) can obtain performance equivalent to that of the vibration type actuator 201. Further, in the vibration type actuator 202, the vibrating body unit 26 can be connected to the support member 15 by the connecting portion 14. Therefore, it is not necessary to provide other support mechanisms on the support member 15 side, and thus, a required level of rigidity of the support member 15 is lowered. Therefore, the support member 15 can be reduced in weight and size, and the entire vibration type actuator 202 can be reduced in size and weight. For example, when the contact body 4 is made of stainless steel metal, the bending rigidity of the support member 15 can be made smaller than the bending rigidity of the contact body 4 in the y direction. Therefore, the support member 15 may be formed of resin or the like, and weight reduction can be achieved.

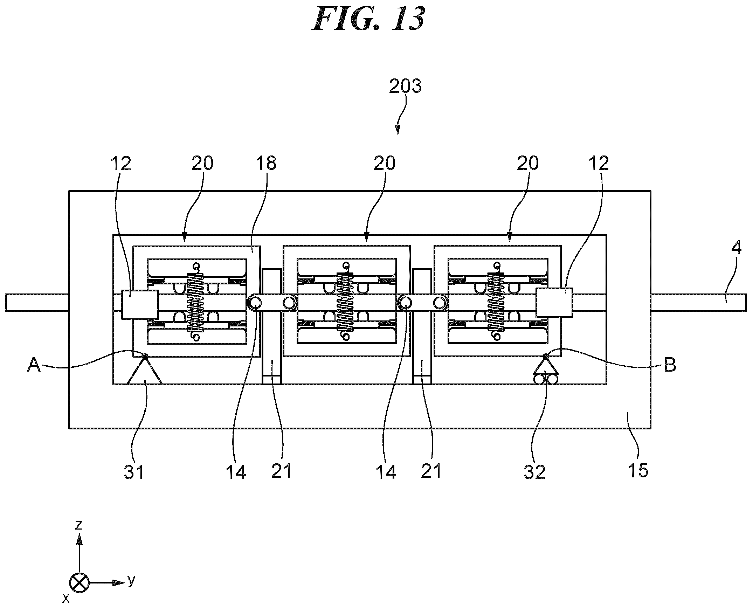

FIG. 13 is a front view showing a schematic configuration of a vibration type actuator 203 according to a fifth embodiment. Among the components of the vibration type actuator 203, components corresponding to the above-described components of each vibration type actuator will be described using the same names and reference numerals, and description of common functions and configurations thereof will be omitted.

The vibration type actuator 203 includes three vibrating body units 20 that are arranged in series in the y direction, which is the movement direction of the contact body 4, and drive the contact body 4 in the y direction. The contact body support portions 12 are provided at each of a left end portion of the vibrating body unit 20 located on the left side and a right end portion of the vibrating body unit 20 located on the right side among the three vibrating body units 20. More specifically, the contact body support portions 12 are disposed in the holding portions 18 constituting the vibrating body units 20, restrict the degree of freedom of the contact body 4 in the x direction, and guide the contact body 4 in the y direction.

The holding portion 18 of the left vibrating body unit 20, out of the three vibrating body units 20, is supported by the support member 15 via the rotation fulcrum type restriction portion 31. The restriction portion 31 is, for example, a hinge, an elastic hinge, or the like. The restriction portion 31 rotatably supports the vibrating body unit 20 about an axis parallel to the x axis and passing through a fulcrum A, and restricts positions in the y direction and the z direction of the supported vibrating body unit 20. The left vibrating body unit 20 is relatively positioned with respect to the support member 15 by the restriction portion 31. Thus, the contact body 4 is also accurately positioned with respect to the support member 15 by the contact body support portions 12 provided in the left vibrating body unit 20.

Meanwhile, the holding portion 18 of the right vibrating body unit 20, out of the three vibrating body units 20, is supported by the support member 15 via the moving fulcrum type restriction portion 32. The restriction portion 32 includes, for example, a roller and a linear guide. The restriction portion 32 rotatably supports the vibrating body unit 20 around an axis parallel to the x axis and passing through a fulcrum B. The position of the vibrating body unit 20 in the x direction is restricted by the restriction portion 32, but the vibrating body unit is movable by a certain distance in the y direction.

Among the three vibrating body units 20, the center vibrating body unit 20 is connected to the left and right vibrating body units 20 by the connecting portions 14, and the connection method thereof is similar to the connection method of the right and center vibrating body units 20 in the vibration type actuator 201 (see FIG. 10A). That is, displacement (movement) in the x direction of the connecting portion 14 connecting the right vibrating body unit and the center vibrating body unit 20 is regulated by the displacement suppressing portion 21.

As described above, in the vibration type actuator 203, it is possible to obtain performance equivalent to that of the vibration type actuator 201 with a support structure different from that of the vibration type actuator 201. Further, in the vibration type actuator 203, since the contact body support portion 12 is provided not in the support member but in a part of the vibrating body unit 20, relative positioning accuracy between the contact body 4 and the vibrating body 1 can be improved. At this time, positioning accuracy of the contact body 4 in the y direction and the z direction with respect to the support member 15 can be improved by the contact body support portions 12 being provided in the vibrating body unit 20 located on both outer sides (left and right in the y direction (left-right direction)) in the movement direction of the contact body 4.

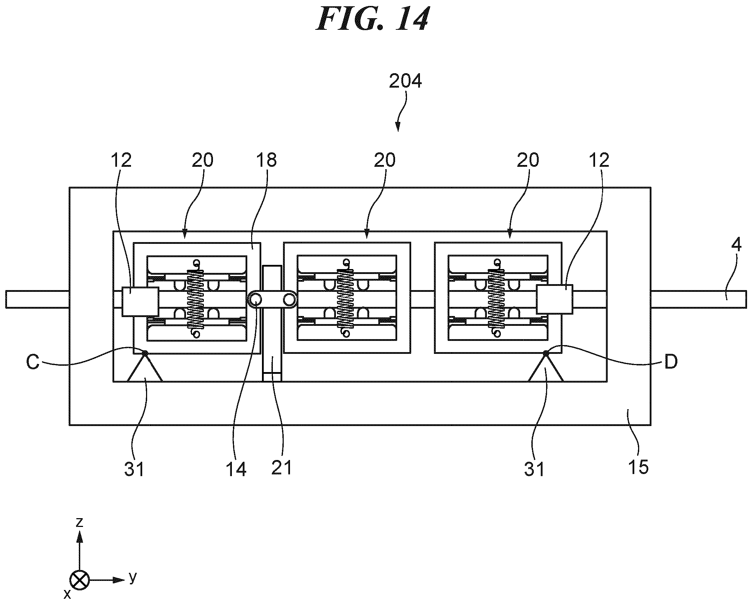

FIG. 14 is a front view showing a schematic configuration of a vibration type actuator 204 according to a sixth embodiment. Among the components of the vibration type actuator 204, components corresponding to the above-described components of each vibration type actuator will be described using the same names and reference numerals, and description of common functions and configurations thereof will be omitted.

The vibration type actuator 204 includes three vibrating body units 20 that are arranged in series in the y direction, which is the movement direction of the contact body 4, and drive the contact body 4 in the y direction. In the vibration type actuator 204, similarly to the vibration type actuator 203 (see FIG. 13), the contact body support portions 12 are provided at each of the left end portion of the left vibrating body unit 20 and the right end portion of the right vibrating body unit 20, among the three vibrating body units 20.

Each of the holding portions 18 of the left and right vibrating body units 20 is supported by the support member 15 via a rotation fulcrum type restriction portion 31. The restriction portion 31 supports the left vibrating body unit 20 rotatably around an axis parallel to the x axis and passing through a fulcrum C. Similarly, the other restriction portion 31 supports the right vibrating body unit 20 rotatably around an axis parallel to the x axis and passing through a fulcrum D. In this way, the positions of the left and right vibrating body units 20 in the y direction and the z direction are restricted by the restriction portions 31. The center vibrating body unit 20 is connected to the left vibrating body unit 20 by a connecting portion 14. The connecting method and restriction of the degree of freedom in the x direction by the displacement suppressing portion 21 are similar to those of the center vibrating body unit of the vibration type actuator 201 (see FIG. 10A).

As described above, in the vibration type actuator 204, it is possible to obtain performance equivalent to that of the vibration type actuator 201 with a support structure different from that of the vibration type actuator 201. In the fifth and sixth embodiments, the examples of the support manner of the vibrating body units using the restriction portions 31 and 32 has been described. However, a support manner of the vibrating body unit is not limited thereto, and an appropriate restriction portion may be selected in view of the internal structure of the support member 15 which is often restricted by applications and specifications.

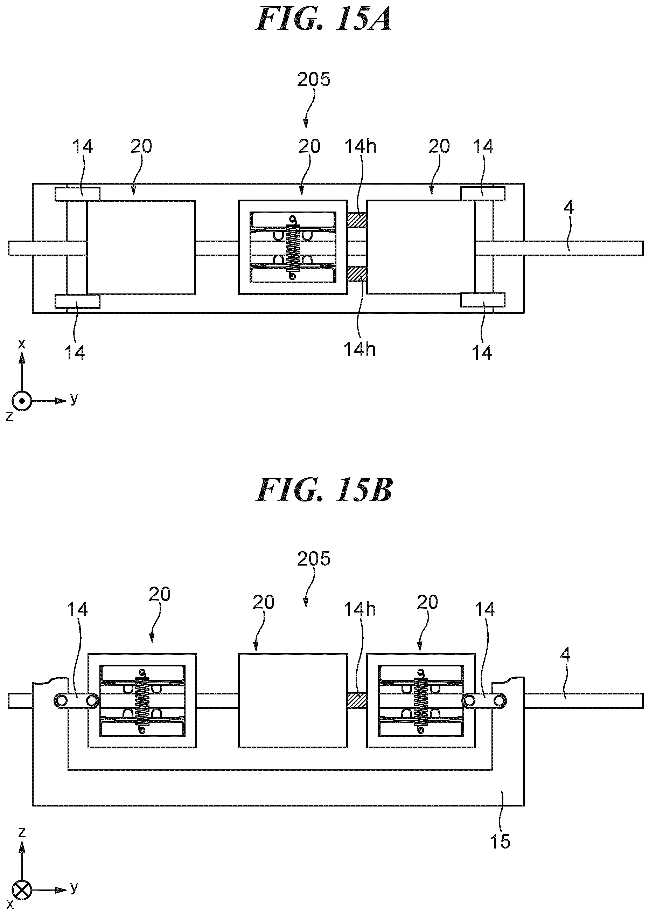

FIG. 15A is a plan view showing a schematic configuration of a vibration type actuator 205 according to a seventh embodiment. FIG. 15B is a front view of the vibration type actuator 205. Here, in order to clarify the support structure of the vibrating body unit 20, the +z-side portion of the support member 15 is omitted. In addition, among the components of the vibration type actuator 205, components corresponding to the above-described components of the respective vibration type actuators will be described using the same names and reference numerals, and description of common functions and configurations thereof will be omitted.

The vibration type actuator 205 includes three vibrating body units 20 that are arranged in series in the y direction, which is the movement direction of the contact body 4, and drive the contact body 4 in the y direction. Similarly to the left and right vibrating body units 20 of the vibration type actuator 201, the left and right vibrating body units 20 are connected to the support member 15 by a total of four connecting portions 14. The center vibrating body unit 20 is arranged in a manner rotated by 90° around an axis parallel to the y axis with respect to the left and right vibrating body units 20. The center vibrating body unit 20 is connected to the right vibrating body unit 20 by two connecting portions 14h shown in FIG. 5C. The spherical portions 14g of the connecting portion 14h are rotatably fitted into spherical holes (not shown) provided in the holding portion 18. It should be noted that FIGS. 15A and 15B show a state in which only the link member 14f appears in appearance. With the two connecting portions 14h supporting the center vibrating body unit 20, the center vibrating body unit 20 is configured to be displaceable in the x direction and the z direction following the shape of the contact body 4.

As described above, in the vibration type actuator 205, a plurality of vibrating body units 20 are arranged at different angles on the plane (zx plane) orthogonal to the movement direction of the contact body 4. That is, the protrusions 2a are also arranged at different angles between the vibrating body units 20. As a result, the protrusion 2a of the vibrating body 1 can also function as the contact body support portion 12. As a result, it is not necessary to separately provide the contact body support portion 12, which makes it possible to reduce the size, weight, and cost by reducing the number of components.

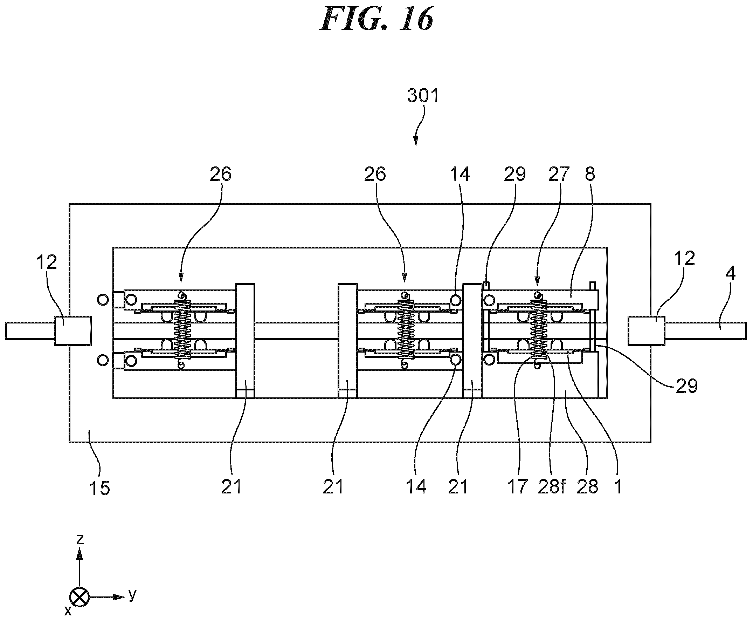

FIG. 16 is a front view showing a schematic configuration of a vibration type actuator 301 according to an eighth embodiment. Among the components of the vibration type actuator 301, components corresponding to the above-described components of each vibration type actuator will be described using the same names and reference numerals, and description of common functions and configurations thereof will be omitted.

The vibration type actuator 301 includes a total of three vibrating body units including two vibrating body units 26 and one vibrating body unit 27 that are arranged in series in the y direction, which is the movement direction of the contact body 4, and drive the contact body 4 in the y direction. Since the support structure of the left and center vibrating body units 26 is similar to that of the vibration type actuator 202 (fourth embodiment, FIG. 12), the description thereof will be omitted.

The right vibrating body unit 27 includes two vibrating bodies 1 arranged to face each other with the contact body 4 interposed therebetween in the z direction (up-down direction). One upper vibrating body 1 is supported by the holding portion 8, and the lower vibrating body 1 is supported by the holding portion 28. The holding portion 28 is fixed to the support member 15 by screwing, bonding, or the like. A plurality of support guide portions 29 is attached to the holding portion 28. Each support guide portion 29 is configured by a slide pin, a linear guide, or the like. The support guide portions 29 restrict the holding portion 8 at the shown positions in the x direction and the y direction (regulates displacement in the x direction and the y direction), while giving a degree of freedom in the z direction of the holding portion 8. Therefore, in the vibrating body unit 27, the holding portion 8 can be relatively displaced in the z direction with respect to the holding portion 28. If gaps provided between the holding portion 8 and the support guide portions 29 are too large, there is a possibility that the generated thrust is reduced due to the inclination of the holding portion 8. Therefore, in order to smoothly displace the holding portion 8 in the z direction, for example, it is desirable to set an allowable range for inclination (pitching) in the yz plane and inclination (rolling) in the zx plane and then to provide this gap as small as possible.

In the vibration type actuator 301, the holding portion 28 is fixed to the support member 15, and hence in addition to the effects obtained by the vibration type actuator according to each of the above embodiments, it is possible to attain an effect that the contact body 4 can be positioned based on the position of the vibrating body 1 installed in the holding portion 28. It should be noted that, in the vibration type actuator 301, the vibrating body unit 27 can be used as a left vibrating body unit instead of the vibrating body unit 26. In this case, since the two holding portions 28 are fixed to the support member 15, it is desirable that a total of four protrusions 2a of the two vibrating bodies 1 supported by the two holding portions 28 be uniformly pressed against the contact body 4. Examples of the configuration for this include a configuration in which the distance between the right vibrating body unit 27 and the left vibrating body unit 27 is sufficiently long, and a configuration in which the bending rigidity of the support member 15 in the y direction is set sufficiently smaller than the bending rigidity of the contact body 4.

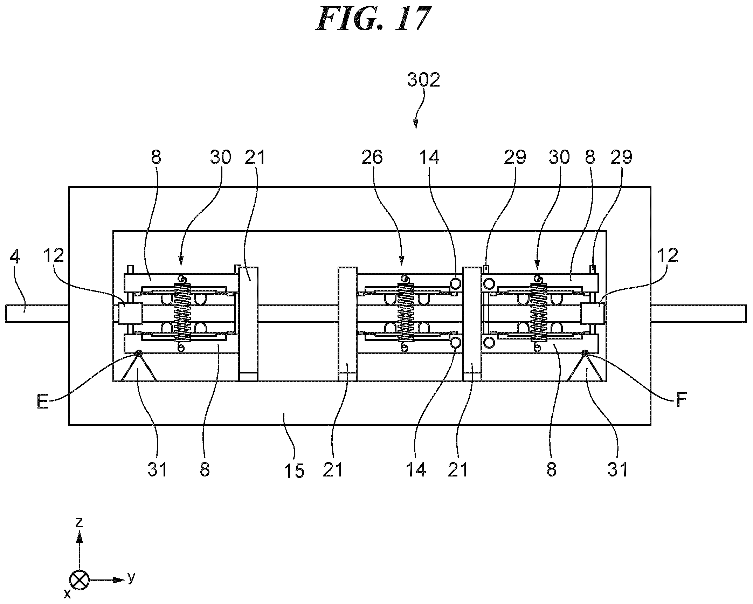

FIG. 17 is a front view showing a schematic configuration of a vibration type actuator 302 according to a ninth embodiment. Among the components of the vibration type actuator 302, components corresponding to the above-described components of each vibration type actuator will be described using the same names and reference numerals, and description of common functions and configurations thereof will be omitted.

The vibration type actuator 302 includes a total of three vibrating body units including one vibrating body unit 26 and two vibrating body units 30 that are arranged in series in the y direction, which is the movement direction of the contact body 4, and drive the contact body 4 in the y direction. Since a support structure of the vibrating body unit 26 arranged at the center among the three vibrating body units is similar to that of the vibration type actuator 202 (fourth embodiment, FIG. 12), the description thereof will be omitted.

The support guide portion 29 is fixed to the holding portion 8 on the lower side of each of the left and right vibrating body units 30 among the three vibrating body units. The configuration of the support guide portion 29 and the support manner of the upper holding portion 8 are similar to those of the vibrating body unit 27 of the vibration type actuator 301 (see FIG. 16). In the vibration type actuator 302, the contact body support portion 12 is provided in the support guide portion 29. A method of supporting and guiding the contact body 4 by the contact body support portion 12 are similar to those of the vibration type actuator 203 (see FIG. 13).

Each of the holding portions 18 of the left and right vibrating body units 30 is supported by the support member 15 via a rotation fulcrum type restriction portion 31. The restriction portion 31 rotatably supports the left vibrating body unit 30 around an axis parallel to the x axis and passing through a fulcrum E. The other restriction portion 31 rotatably supports the right vibrating body unit 30 around an axis parallel to the x axis and passing through a fulcrum F. **In** this way, the positions of the left and right vibrating body units 30 in the y direction and the z direction are restricted by the restriction portion 31. As described above, in the vibration type actuator 302, it is possible to obtain performance equivalent to that of the vibration type actuator 301 with a support structure different from that of the vibration type actuator 301.

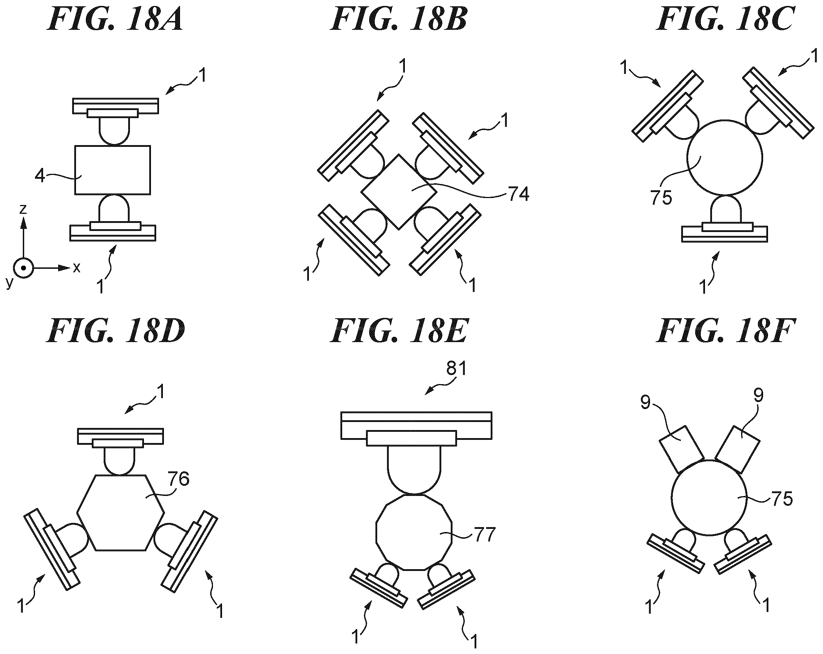

Next, configurations applicable to the vibration type actuator according to each of the above-described embodiments will be described. That is, examples of a configuration in which one vibrating body unit includes a plurality of vibrating bodies, and the protrusion of each vibrating body is brought into contact with and supported by the contact body will be described. Each of FIGS. 18A to 18F is a schematic view for describing a structure for supporting a contact body by the plurality of vibrating bodies, and is simply shown when viewed from a y direction which is a movement direction of the contact body. It should be noted that the coordinate axes are shown only in FIG. 18A, and are omitted in FIGS. 18B to 18F. Although the nonwoven fabric, the spacer, the pressurizing unit, and the holding portion for the vibrating body are not shown in FIGS. 18A to 18F, those described in the above embodiments can be appropriately selected and used.

FIG. 18A shows a configuration in which two vibrating bodies 1 facing each other support the contact body 4, and is used in, for example, the vibration type actuator 201 (see FIG. 10A). FIG. 18B shows a configuration in which the vibrating body 1 is disposed on each of four side surfaces of a contact body 74 having a rectangular cross section, to support the contact body 74. FIG. 18C shows a configuration in which a substantially cylindrical side surface (curved surface) of a contact body 75 having a substantially circular cross section is supported by the three vibrating bodies 1 arranged at intervals of approximately 120° on the same zx plane.

FIG. 18D shows a configuration in which the vibrating body 1 is disposed on each of three side surfaces among the side surfaces of a contact body 76 having a polygonal cross section, to support the contact body 76. FIG. 18E shows a configuration in which three side surfaces among the side surfaces of a contact body 77 having a polygonal cross section are supported by the vibrating bodies 1 and 81 having different sizes and thrusts, respectively. FIG. 18F shows a configuration in which a substantially cylindrical side surface of the contact body 75 having a substantially circular cross section is supported by the two vibrating bodies 1 and the two reaction force receiving portions 9. By selecting and using these configurations, the contact body can be more appropriately supported by the vibrating body regardless of the cross-sectional shape of the contact body.

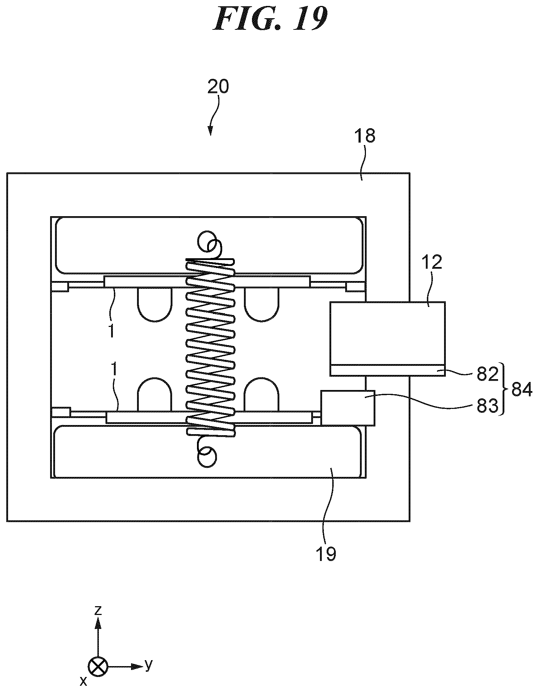

Next, an example of a configuration in which a displacement detection unit is provided in the vibrating body unit constituting the vibration type actuator according to each of the above-described embodiments will be described. FIG. 19 is a front view showing a state in which a displacement detection unit 84 is attached to the vibrating body unit 20. Although the vibrating body unit 20 is taken up here, the displacement detection unit 84 can also be mounted on another vibrating body unit (26, 27, etc.) or the like.

The displacement detection unit 84 includes a scale 82 and a detector 83. The scale 82 is attached to a position at which the scale does not physically interfere with (in not contact with) the contact body 4 (not shown in FIG. 19) in the contact body support portion 12 provided in the holding portion 18. The scale 82 rotates together with the contact body support portion 12 according to the displacement of the contact body 4. The detector 83 detects a movement amount in the y-direction of the contact body 4 by reading the rotational displacement of the scale 82. The light source unit included in the detector 83 irradiates the scale 82 with light, and a light receiving unit of the detector 83 receives reflected light on the scale 82, whereby the rotational displacement of the scale 82 can be read. It is possible to control drive parameters such as the position, speed, and acceleration of the contact body 4 on the basis of the movement amount in the y-direction of the contact body 4 output by the detector 83.

It should be noted that, in a case where the displacement detection unit 84 is provided in the vibrating body unit supported by the restriction portion 31 or the like, the movement amount can be detected with higher accuracy. Furthermore, as the displacement detection unit 84, various types such as an optical type, a magnetic type, and a capacitance type can be adopted. Here, the optical reflection type displacement detection unit has been described as the displacement detection unit 84, but a transmission type displacement detection unit can also be used as the optical displacement detection unit 84. Furthermore, instead of the rotation type displacement detection unit 84, a linear motion type displacement detection unit in which a linear motion type scale is arranged on the contact body 4 and a detector is arranged on the vibrating body unit may be adopted. By applying the displacement detection unit 84 to the vibrating body unit positioned with respect to the support member 15 by being restricted by the restriction portion 31 or the like, it is possible to detect the relative position of the contact body 4 with respect to the support member 15.

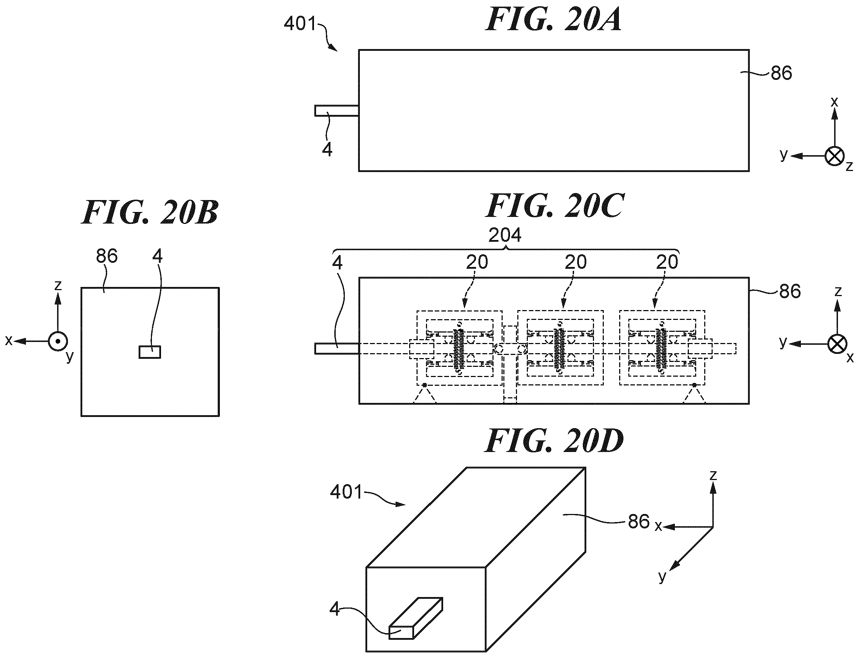

FIGS. 20A to 20D are views for describing a schematic configuration of an actuator unit 401 according to a tenth embodiment, and are a plan view (top view) (FIG. 20A), a side view (FIG. 20B), a front view (FIG. 20C), and a perspective view (FIG. 20D) of the actuator unit 401. Among the components of the actuator unit 401, components corresponding to the above-described components of the respective vibration type actuators will be described using the same names and reference numerals, and description of common functions and configurations thereof will be omitted.

The actuator unit 401 is obtained by packaging the vibration type actuator 204 using an exterior member 86. That is, in the actuator unit 401, the holding portion 18 of the vibration type actuator 204 is movably fixed to an inner bottom surface of the exterior member 86 via the restriction portion 31. Then, the contact body 4 moves in the y direction in a state of penetrating an end surface (zx surface) of the exterior member 86 to take out power of the contact body 4. With such a configuration, the actuator unit 401 has an appearance in which only the contact body 4 of the vibration type actuator 204 is exposed from the exterior member 86. It should be noted that the vibrating body unit 20 and the like covered by the exterior member 86 and invisible are indicated by broken lines in FIG. 20C.

As described above, by packaging the vibration type actuator 204 with the exterior member 86 to form the actuator unit 401, the user can hold and handle the exterior member 86 safely, and the vibration type actuator 204 can be protected. It should be noted that although the example in which the vibration type actuator 204 is packaged has been described here, all the vibration type actuators according to the above-described embodiments can be unitized using the exterior member 86 without exception. It should be noted that the exterior member 86 may be integrally formed with the support member 15, the restriction portion 31, and the like. Instead of the restriction portion 31, another mechanical element or mechanical component having the equivalent function to that of the restriction portion 31 can be used.

FIGS. 21A to 21D are views for describing a schematic configuration of an actuator unit 402 according to an eleventh embodiment, and are a plan view (top view) (FIG. 21A), a side view (FIG. 21C), and a perspective view (FIG. 21D) of the actuator unit 402. FIG. 21B is a plan view with exterior members 90 and 92 and the displacement suppressing portion 21 constituting the actuator unit 402 not shown.

The actuator unit 402 includes three vibrating body units 40 each having the vibrating body 1, and the three vibrating body units 40 are held by a cylindrical columnar exterior member 92. The three vibrating body units 40 are arranged on a circumference of the exterior member 92 such that adjacent holding portions 8 that respectively hold the vibrating bodies 1 are connected by the connecting portion 14h (see FIG. 5C).

A contact body 91 has an annular shape (ring shape). In a state where the contact body 91 is rotatably supported by a rotation support mechanism (not shown), one xy surface of the contact body 91 is in contact with the protrusions 2a of the three vibrating bodies 1. The rotation support mechanism of the contact body 91 is, for example, a shaft support mechanism configured by a rolling bearing, a sliding bearing, or the like. The exterior member 90 is attached to the other xy surface of the contact body 91.

In the actuator unit 402, when the vibrating body units 40 are driven, the contact body 91 and the exterior member 90 integrally rotate relative to the exterior member 92 about an axis that passes through the center of the xy plane of the exterior member 90 and is parallel to the z axis. That is, the actuator unit 402 outputs the rotational motion of the exterior member 90 to the outside as power.

The configuration of the vibrating body unit 40 will be described in more detail. The vibrating body unit 40 includes the holding portion 8, the vibrating body 1, the pressurizing unit 7, and a spacer to which a nonwoven fabric (not shown) is attached. A method of pressing the vibrating body 1 against the contact body 91 using the pressurizing unit 7 is similar to the method of pressing the vibrating body 1 against the contact body 4 in the vibrating body unit 5 of the vibration type actuator 101 (see FIG. 3). Among the three vibrating body units 40, the vibrating body unit 40 on the left side in FIG. 21C is connected, using the connecting portion 14h, to a support member 93 fixed to the exterior member 92. The remaining two vibrating body units 40 are sequentially connected toward the right side using the connecting portion 14h. Therefore, even when deformation such as deflection occurs in the contact body 4 in the circumferential direction, the vibrating body 1 of each of the three vibrating body units 40 can be displaced following the deformation of the contact body 4.

As described above, by packaging the vibrating body unit 40 and the contact body 91 with the exterior members 90 and 92 to form the actuator unit 402, the user can hold and handle the exterior members 90 and 92 safely, and the vibrating body unit 40 can be protected, as in the tenth embodiment.

In the actuator unit 402, the connecting portion 14h is restricted by the displacement suppressing portion 21 fixed to the exterior member 92 so that the vibrating body unit 40 is not displaced in the radial direction. At this time, it is desirable to appropriately design the shape of the connecting portion 14 and the position of the displacement suppressing portion 21 so that the vibrating body 1 frictionally slides in approximately central portion (a portion indicated by an alternate long and short dash line G in FIG. 21B) of the contact body 91. Further, by connecting the vibrating body units 40 in the circumferential direction by using the connecting portion 14, it is possible to take a larger empty space surrounded by a broken line H in FIG. 21B. The empty space thus generated can be effectively used as an arrangement space for the displacement detection unit, the circuit board, and the like, which can downsize the actuator unit 402.

It should be noted that the actuator unit 402 includes three connected vibrating body units 40. However, from the viewpoint of displacing the vibrating bodies 1 of the connected vibrating body units 40 following the deformation of the contact body 91, two or more vibrating body units 40 connected may be enough. In the tenth and eleventh embodiments, it is desirable that the actuator unit is configured by packaging while selecting the configuration of the vibration type actuator and appropriately adjusting the arrangement and the number of the vibrating body units so as to match the specification of the device to which the actuator unit is applied.

In the following embodiments, application examples of the above-described various vibration type actuators, that is, various devices equipped with the vibration type actuators will be described.

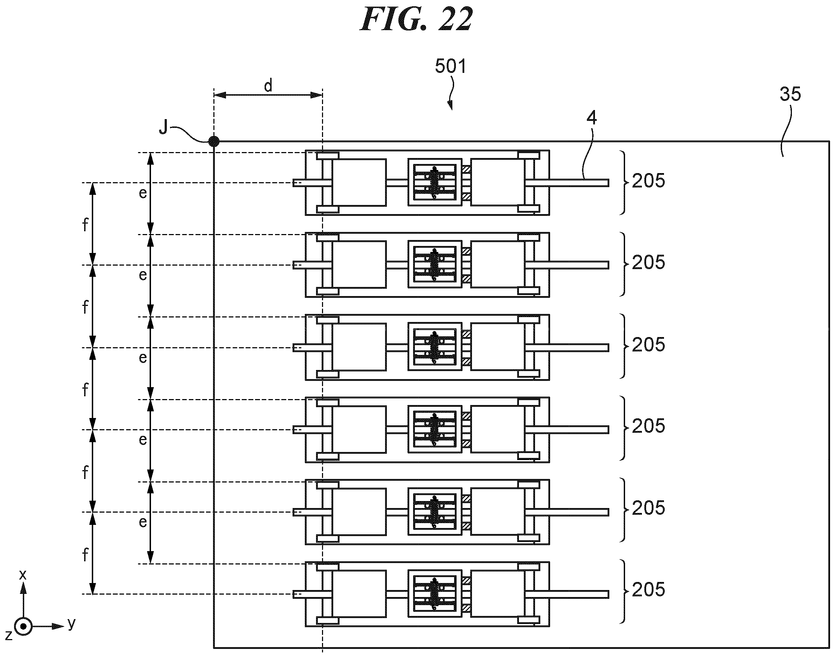

FIG. 22 is a plan view showing a schematic configuration of a device 501 according to a twelfth embodiment. The device 501 includes six vibration type actuators 205 (see FIGS. 15A and 15B) and a support member 35. The six vibration type actuators 205 are fixed to the support member 35 via the support member 15, with the connecting portion 14 or the support member 15 as a reference position in the vibration type actuator 205. The support member 35 corresponds to the support member 15 enlarged in the xy plane, and is formed as one member.

As shown by the device 501, it is easy to arrange the six vibration type actuators 205 in an aligned manner on a plane. For example, the six vibration type actuators 205 can be easily aligned such that the reference position in the vibration type actuator 205 is separated from a reference position J of the support member 35 by a distance d in the y direction and an interval between reference positions in the two adjacent vibration type actuators 205 is a distance e in the x direction. In this case, intervals between the contact bodies 4 of the two vibration type actuators 205 adjacent to each other in the x direction can all be set to the same distance f (can be unified to the distance f). The contact bodies 4 of the six vibration type actuators 205 may be connected to one drive component or may be connected to different drive components.

It should be noted that although the device 501 including the six vibration type actuators 205 has been described above, a device similar to the device 501 may be configured using any plurality of vibration type actuators 205. In addition, depending on the configuration of the device, the plurality of vibration type actuators can be arranged at arbitrary positions on the same plane or different planes.

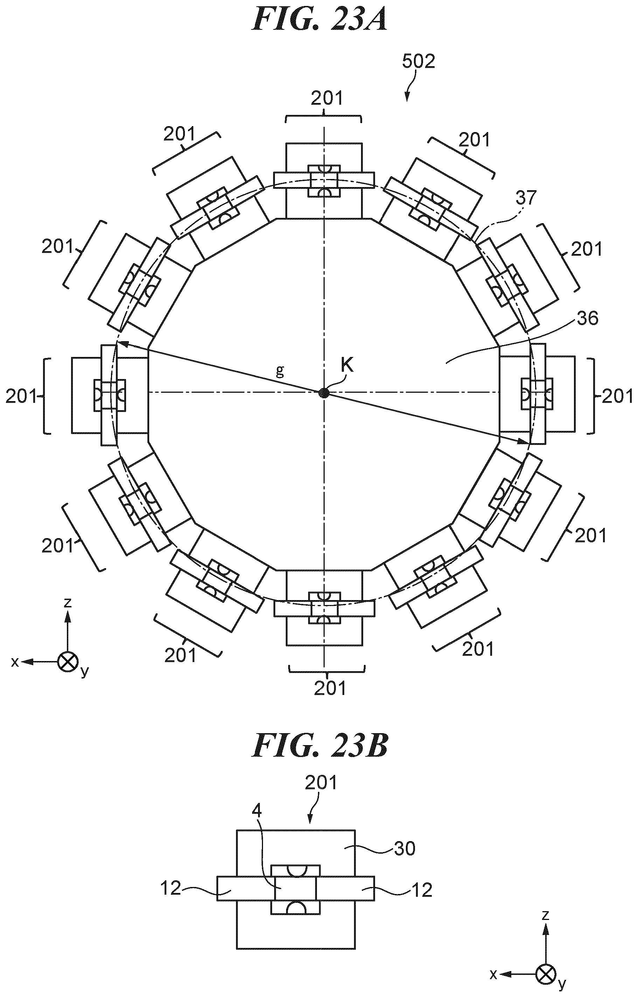

FIG. 23A is a plan view showing a schematic configuration of a device 502 according to a thirteenth embodiment. FIG. 23B is a side view showing a schematic configuration of the vibration type actuator 201 constituting the device 502. The device 502 includes 12 vibration type actuators 201 (see FIG. 10A) and a support member 36. By the support member 36, 12 vibration type actuators 201 whose axial direction is the y direction are formed as one member in a columnar shape. Specifically, a cross section orthogonal to the y direction of the support member 36 shows a substantially regular dodecagon centered on a point K, and the 12 vibration type actuators 201 are arranged such that the support member 15 of one vibration type actuator 201 is in contact with each side. Each of the 12 vibration type actuators 201 is radially fixed to the 12 side surfaces of the support member 36 via the support member 15 with the support member 15 as a reference position. It should be noted that 12 side surfaces of the support member 36, that is, 12 surfaces parallel to the y axis, are 12 side surfaces corresponding to each side of a substantially regular dodecagon of the zx cross section of the support member 36. Thus, in the device 502, a plurality of (here, 12) contact bodies 4 can be accurately arranged on the circumference of the pitch circle 37 having the diameter g and centered at the point K when viewed from the y direction. It should be noted that, in the device 502, the vibration type actuator 201 is disposed on all the side surfaces of the support member 36, but the vibration type actuator 201 may be disposed at any position on any side surface of the support member 36. Further, the support member 36 is not limited to the dodecagonal prism, and may be any polygonal prism.

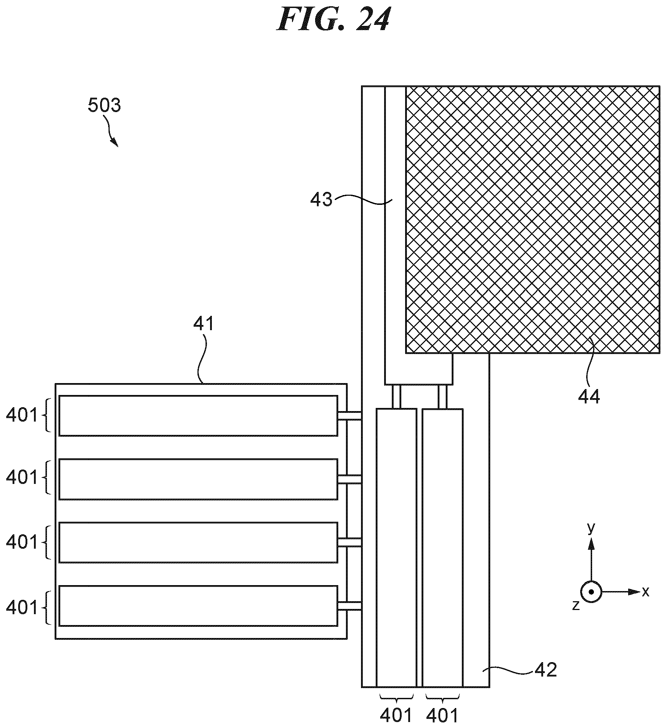

FIG. 24 is a plan view showing a schematic configuration of a multi-axis stage 503 according to a fourteenth embodiment. The multi-axis stage 503 includes a fixing portion 41, an x-stage 42, a y-stage 43, and an xy-stage 44.

The fixing portion 41 has restricted degrees of freedom in all directions and is immovable. The four actuator units 401 (see FIGS. 20A to 20D) are arranged in the y direction and fixed to the fixing portion 41 in a manner similar to that for the device 501 described with reference to FIG. 22. The four contact bodies 4 of the four actuator units 401 fixed to the fixing portion 41 are movable in the x direction in FIG. 24, and right ends thereof are fixed to the x-stage 42.

The x-stage 42 is movable only in the x direction, and a degree of freedom in other directions is restricted. The x-stage 42 is driven in the x direction by four actuator units 401 fixed to the fixing portion 41. On the x-stage 42, two actuator units 401 are fixed side by side in the x direction. The two contact bodies 4 of the two actuator units 401 fixed to the x-stage 42 are movable in the y-direction, and upper ends thereof are fixed to the y-stage 43.

The y-stage 43 is movable only in the y-direction, and a degree of freedom in other directions is restricted. The y-stage 43 is driven in the y-direction by two actuator units 401 fixed to the x-stage 42. An xy-stage 44 is fixed to the y-stage 43. In conjunction with the movement of the x-stage 42 and/or the y-stage 43, the xy-stage 44 moves in the xy-plane.

The mass to be moved by the actuator units 401 provided in the fixing portion 41 is larger than the mass to be moved by the actuator units 401 provided in the x-stage 42. In consideration of this, the number of actuator units 401 arranged in each of the fixing portion 41 and the x-stage 42 may be set corresponding to a mass of an object to be moved. The multi-axis stage 503 is configured as an xy-stage having two degrees of freedom, but the multi-axis stage is not limited thereto, and a stage having an arbitrary degree of freedom can be realized using an arbitrary number of actuator units 401.

The multi-axis stage 503 has a structure in which the drive target can be moved in the predetermined direction by the plurality of actuator units 401, which suppresses the generation of the moment in the plane parallel to the xy plane. As a result, the xy-stage 44 can be accurately moved in the xy plane.

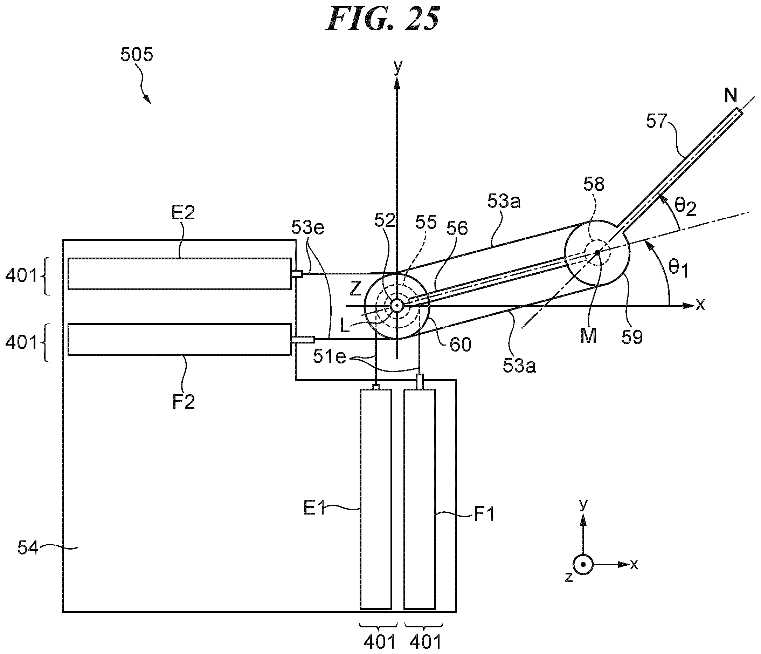

FIG. 25 is a plan view showing a schematic configuration of an articulated robot 505 according to a fifteenth embodiment. The articulated robot 505 is an example of an articulated robot adopting an antagonistic driving system. The articulated robot 505 includes a first joint 52, a fixing portion 54, a first pulley 55, a first link 56, a second link 57, a second joint 58, a second pulley 59, a third pulley 60, a wire 51e, and a wire 53e. In the following description, in order to distinguish the plurality of actuator units 401 provided in the fixing portion 54, reference signs E1, F1, E2, and F2 are given to the actuator units 401, respectively.

The first joint 52 has a rotational degree of freedom rotatable about an axis parallel to the z axis, centered on a point L. The second joint 58 has a rotational degree of freedom rotatable about an axis parallel to the z axis, centered on a point M, and is restricted by the motion of the first link 56. The first pulley 55 indicated by a broken line is restricted by the first link 56 and is rotatably provided about the first joint 52 (point L). The second link 57 is provided so as to be rotatable about the second joint 58 (point M) via the second joint 58. The second pulley 59 is restricted by the second link 57. The third pulley 60 is rotatably provided about the first joint 52 (point L).

The wire 51e is wound around the first pulley 55, and has one end coupled to the contact body 4 of the actuator unit F1 and the other end coupled to the contact body 4 of the actuator unit E1. The wire 53e is wound around the third pulley 60, and has one end coupled to the contact body 4 of the actuator unit F2 and the other end coupled to the contact body 4 of the actuator unit E2. A wire 53a is formed in an endless shape (loop shape) and is bridged between the second pulley 59 and the third pulley 60.

Each of the actuator units E1 and F1 arranged such that the contact body 4 is movable in the y direction in FIG. 25 drives the wire 51e in the y direction. When each of the actuator units E1 and F1 generates a thrust in the y direction so that the wire 51e is not loosened, a frictional force is generated between the wire 51e and the first pulley 55 by a difference between the generated thrusts, which rotates the first link 56 about the first joint. As a result, the actuator units E1 and F1 can cause the first link 56 to be displaced by an angle θ1 with respect to the x axis.

Similarly, each of the actuator units E2 and F2 arranged such that the contact body 4 is movable in the x direction in FIG. 25 drives the wire 53e in the x direction. When each of the actuator units E2 and F2 generates a thrust in the x direction so that the wire 53e is not loosened, a frictional force is generated between the wire 53e and the third pulley 60 by a difference between the generated thrusts, which rotates the third pulley 60. As a result, the first link 56 can be rotated about the first joint 52. When the third pulley 60 rotates, frictional force is generated between the wire 53a and the third pulley 60, and the wire 53a is driven. When the wire 53a is driven, frictional force is generated between the wire 53a and the second pulley 59, and the second pulley 59 rotates. As a result, the second link 57 can be rotated about the second joint 58. That is, the actuator units E2 and F2 can cause the first link 56 to be displaced by the angle θ1 with respect to the x axis in FIG. 25 and can cause the second link 57 to be displaced by an angle Θ2 with respect to the first link 56. It should be noted that, at that time, by driving the actuator units E1 and F1 so as to cancel the displacement by the angle θ1 of the first link 56 caused by the driving of the actuator units E2 and F2, only the displacement by the angle θ2 of the second link 57 can be caused.

In this way, the articulated robot 505 can cause a tip N of the second link 57 to reach the target position in the xy plane by driving the actuator units 401. Then, by performing antagonistic driving in a state where tension is constantly applied to the wires 51e and 53e so as not to be loosened, it is possible to suppress occurrence of rattling around the joint and deviation due to buckling of the wires 51e and 53e. As a result, torsional rigidity around each joint can be increased. In addition, the tip N can be positioned with high accuracy.

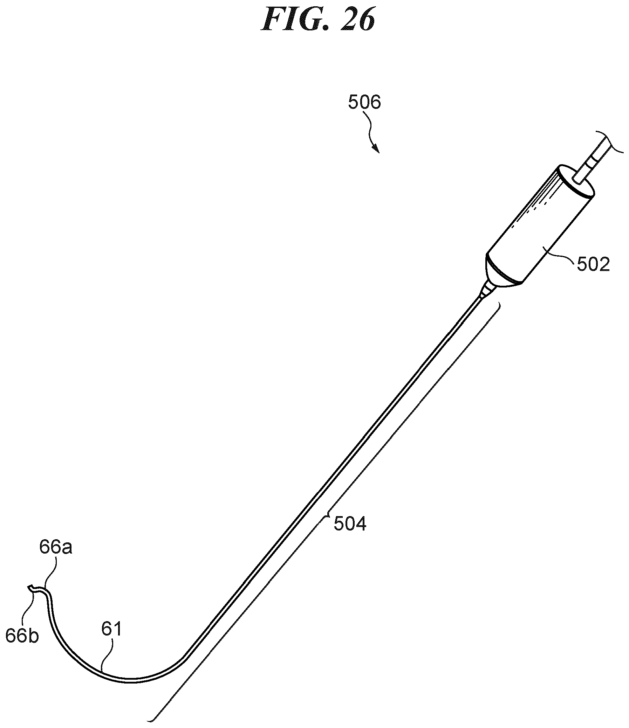

FIG. 26 is a plan view showing a schematic configuration of an articulated robot 506 according to a sixteenth embodiment. The articulated robot 505 according to the fifteenth embodiment operates in an antagonistic drive system. Meanwhile, the articulated robot 506 operates in a driving system in which the wire is pushed and pulled within a thrust range in which the wire is not buckled.

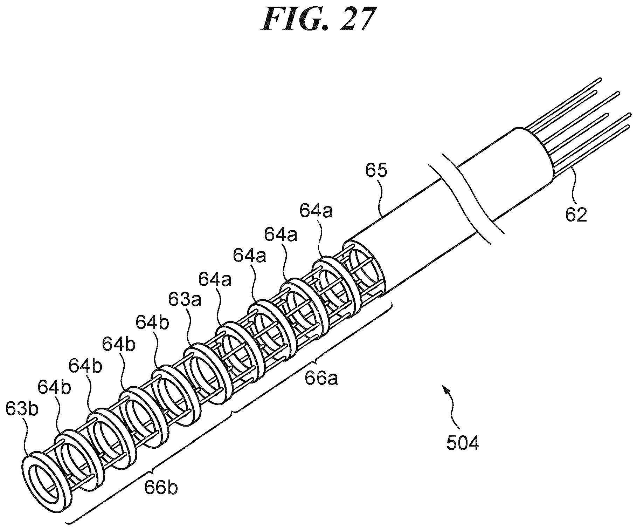

The articulated robot 506 includes a device 502 and a wire drive manipulator 504. FIG. 27 is a perspective view showing a schematic configuration of the wire drive manipulator 504. The wire drive manipulator 504 is equivalent to that described in Japanese Laid-Open Patent Publication (kokai) No. 2018-140101, for example. The wire drive manipulator 504 includes a linear member guide portion 61 and two curved sections 66a and 66b. A linear member 62 can change curvatures of the curved sections 66a and 66b by sliding without buckling a hollow portion of a guide pipe 65 provided in the linear member guide portion 61. It should be noted that, as shown in FIG. 26, the linear member guide portion 61 may have flexibility.

In the wire drive manipulator 504, three linear members 62 are provided per one curved section. Specifically, the tips of the three linear members 62 among the six linear members 62 are fixed to a guide member tip member 63a. One of these three linear members 62 is fixed to a guide member 64a, and the curvature of the curved section 66a is changed by the other two linear members 62 being driven. Similarly, the tip portions of the remaining three linear members 62 among the six linear members 62 are fixed to a tip member 63b. One linear member 62 of these three linear members 62 is fixed to a guide member 64b, and the curvature of the curved section 66b is changed by the other two linear members 62 being driven.

In the articulated robot 506, the device 502 (see FIG. 23A) is used as a drive source of the wire drive manipulator 504. The contact bodies 4 of the vibration type actuators 201 of the device 502 are coupled to the linear members 62, and this configuration is used as a drive source that changes the curvatures of the curved sections 66a and 66b of the wire drive manipulator 504. It should be noted that it is desirable that the device 502 is packaged using the exterior member similarly to the configuration described with reference to FIGS. 20A to 20D, whereby internal components can be appropriately protected, and operability can be improved.

In the articulated robot 506, the device 502 drives the wire drive manipulator 504, which makes it possible to control the curvatures of the curved sections 66a and 66b with high accuracy. In addition, by using the device 502 as a driving unit that drives the wire drive manipulator 504, it is possible to reduce the driving unit in size and weight, which makes it improve operability. Furthermore, by increasing or decreasing the number of vibrating body units in the device 502, it is possible to easily cope with the output required for the curved sections 66a and 66b. In addition, when a direct drive type vibration type actuator is used for driving the linear member 62 of the wire drive manipulator 504, responsiveness can be improved as compared with a case of using a driving unit in which an electromagnetic motor and a deceleration mechanism are combined.

The plurality of vibration type actuators 201 constituting the device 502 is constituted by the vibrating body units 20 using a common component, and thus it is possible to easily change the output from each of the vibration type actuators 201 by increasing or decreasing the vibrating body units 20. In addition, by changing the amplitude ratio of the vibration of the plurality of vibration modes excited in the vibrating body 1, it is possible to control the magnitude and the driving speed of the thrust for driving (deforming) the curved sections 66a and 66b. When no voltage is applied to the electromechanical energy conversion element 3, the postures of the curved sections 66a and 66b can be maintained by the static frictional force acting between the protrusion 2a and the contact body 4.

Furthermore, a configuration can be adopted in which by driving the vibrating body 1 only in the second vibration mode (FIG. 2B) to change the frictional force acting between the protrusion 2a and the contact body 4, when an external force acts on the curved sections 66a and 66b, the postures of the curved sections 66a and 66b are changed according to the external force. This configuration can be used, for example, as a safety mechanism for avoiding danger to the human body when the wire drive manipulator 504 touches the human body.

It should be noted that the articulated robot 506 can be applied to, for example, an industrial endoscope, a medical endoscope, and a surgical instrument such as a catheter used for medical practice such as treatment, biopsy, and examination. In addition, the articulated robot 506 has a four-degree-of-freedom configuration including two curved sections 66a and 66b, but the number of curved sections, that is, the degree of freedom can be arbitrarily set. This is possible by setting the shape of the support member 36, the diameter g of the pitch circle 37, and the number and arrangement of the vibration type actuators 201 to appropriate conditions with respect to the device 502 according to the number of curved sections and the diameter of the guide member.

Although the present invention has been described in detail based on the preferred embodiments thereof, the present invention is not limited to these specific embodiments, and various forms without departing from the scope of the present invention are also included in the present invention. Furthermore, each embodiment described above merely shows an embodiment of the present invention, and each embodiment can be appropriately combined.

For example, the connection object to be connected to the vibrating body unit by the connecting portion is another vibrating body unit or a support member in the above embodiments, but is not limited thereto, and may be any portion or any component as long as it can move relative to the contact body. Furthermore, the multi-axis stage 503 and the articulated robots 505 and 506 have been described as examples of devices to which the vibration type actuator and the actuator unit according to each of the above embodiments are applied, but examples of applicable devices are not limited thereto. For example, as another example of the device according to the present invention, various stage devices such as a microscope, a machine tool, and a measurement device, a vertical articulated robot having more degrees of freedom than the articulated robot 505, a parallel link type robot, and the like can be exemplified.

### Other Embodiments

The present invention is not limited to the above embodiments, and various changes and variations can be made without departing from the scope of the present invention. Therefore, the following claims are attached in order to make the scope of the present invention public. The invention is defined by the appended claims.

The present application claims priority based on Japanese Patent Application No. 2020-183713 filed on November 2, 2020.

### Reference Signs List

1 Vibrating body
4 Contact body
5, 11, 20, 26, 27, 30, 40 Vibrating body unit
7, 13, 17 Pressurizing unit
8, 18, 28 Holding portion
9 Reaction force receiving portion
12 Contact body support portion
14 Connecting portion
15, 35, 36 Support member
21 Displacement suppressing portion
29 Support guide portion
31, 32 Restriction portion
101, 102, 201 to 205, 301, 302 Vibration type actuator
501, 502 Device
503 Multi-axis stage
505, 506 Articulated robot

## Claims

1. A vibration type actuator (101, 102, 201-205, 301, 302) comprising:
a vibrating body unit (5, 11, 20, 26, 27, 30, 40) including a vibrating body (1) and a holding portion (8, 18, 28, 8h) configured to hold the vibrating body;
a pressurizing unit (7, 13, 17);
a contact body (4) that comes into contact with the vibrating body by a pressurizing force by the pressurizing unit; and
a connecting portion (14, 14e, 14h),
wherein when predetermined vibration is excited in the vibrating body, the contact body and the vibrating body unit move relative to each other in a first direction, and
the connecting portion connects the holding portion to a connection object in the first direction, such that the vibrating body unit is displaced at least in a pressurizing direction by the pressurizing unit when the contact body and the vibrating body unit move relative to each other in the first direction,
**characterized in that**
the connecting portion (14, 14e, 14h) has a rotational degree of freedom of two or more degrees of freedom, and is restricted by a rotation shaft (14a) or spherical portion (14g) having a rotational degree of freedom of one or more degrees of freedom with respect to the vibrating body unit (5, 11, 20, 26, 27, 30, 40).

2. The vibration type actuator (101, 102, 201-205, 301, 302) according to claim 1,
wherein the connecting portion (14, 14e) includes two cylindrical columnar shaft portions arranged substantially in parallel at a predetermined interval, and
the holding portion (8, 18, 28, 8h) has clearance holes configured to rotatably hold one of the two shaft portions.

3. The vibration type actuator (101, 102, 201-205, 301, 302) according to claim 1,
wherein the connecting portion (14h) has a structure in which spherical portions are provided at both ends of a shaft portion, and
the holding portion (8, 18, 28, 8h) has spherical holes configured to rotatably hold the spherical portions.

4. The vibration type actuator (101, 102, 201-205, 301, 302) according to claim 1 or 2, further comprising a plurality of the vibrating body units (5, 11, 20, 26, 27, 30, 40),
wherein the connecting portion (14, 14e, 14h) connects the two vibrating body units arranged side by side in the first direction, and is restricted by each of the two vibrating body units with a rotational degree of freedom of one degree of freedom.

5. The vibration type actuator (201-204, 301, 302) according to claim 4, further comprising:
a support member (15, 35, 36) configured to support the plurality of vibrating body units (5, 11, 20, 26, 27, 30, 40); and
a displacement suppressing portion (21) attached to the support member and configured to regulate displacement of the connecting portion (14, 14e, 14h) in a second direction orthogonal to the first direction and the pressurizing direction by the pressurizing unit (7, 13, 17).

6. The vibration type actuator (101, 102, 201-204, 301, 302) according to claim 4 or 5, further comprising contact body support portions (12) attached to a holding portion (8, 18, 28, 8h) of each vibration body unit located at each end in the first direction, among the plurality of vibrating body units (5, 11, 20, 26, 27, 30, 40), and configured to movably support the contact body (4) in the first direction.

7. The vibration type actuator (203, 204, 302) according to claim 6, further comprising:
a support member (15, 35, 36) configured to support the vibrating body unit (5, 11, 20, 26, 27, 30, 40); and
a first restriction portion (31, 32) attached to the support member and configured to regulate movement in the first direction of a vibrating body unit located at at least one end in the first direction among the plurality of vibrating body units.

8. The vibration type actuator (203, 204, 302) according to claim 7, wherein the first restriction portion (31, 32) regulates movement of the vibrating body unit (5, 11, 20, 26, 27, 30, 40) in a second direction orthogonal to the first direction and the pressurizing direction by the pressurizing unit (7, 13, 17).

9. The vibration type actuator (203, 204, 302) according to claim 7 or 8, further comprising a second restriction portion (31, 32) attached to the support member (15, 35, 36) and configured to regulate displacement of a vibrating body unit, located at one end in the first direction among the plurality of vibrating body units (5, 11, 20, 26, 27, 30, 40), in the second direction orthogonal to the first direction and the pressurizing direction by the pressurizing unit (7, 13, 17).

10. The vibration type actuator (301) according to any one of claims 5 to 9, further comprising a support guide portion (29) attached to a holding portion (8, 18, 28, 8h) of at least one of the plurality of vibrating body units (5, 11, 20, 26, 27, 30, 40) and configured to regulate displacement of the holding portion in a second direction orthogonal to the first direction and the pressurizing direction by the pressurizing unit (7, 13, 17) and in the first direction.

11. The vibration type actuator (205) according to claim 4 or 5, wherein at least two of the plurality of vibrating body units (5, 11, 20, 26, 27, 30, 40) are arranged such that vibrating bodies (1) of the two vibrating body units are in contact with the contact body (4) at different angles on a plane orthogonal to the first direction.

12. The vibration type actuator (101, 102, 201, 202, 205, 301) according to claim 1 or 2, further comprising a support member (15, 35, 36) configured to support the vibrating body unit (5, 11, 20, 26, 27, 30, 40),
wherein the connecting portion (14, 14e, 14h) connects the vibrating body unit and the support member in a state of being restricted with a rotational degree of freedom of one degree of freedom with respect to each of the vibrating body unit and the support member.

13. The vibration type actuator (101, 102, 201, 202, 205, 301) according to claim 12, further comprising a contact body support portion (12) attached to the support member (15, 35, 36) and configured to movably support the contact body (4) in the first direction.

14. The vibration type actuator (201-204, 301, 302) according to claim 12 or 13, further comprising a displacement suppressing portion (21) attached to the support member (15, 35, 36) and configured to regulate displacement of the connecting portion (14, 14e, 14h) in a second direction orthogonal to the first direction and the pressurizing direction by the pressurizing unit (7, 13, 17).

15. The vibration type actuator (101, 102) according to any one of claims 1 to 14,
wherein the vibrating body unit (5, 11) includes a reaction force receiving portion (9) configured to receive a reaction force of a pressurizing force by which the pressurizing unit (7, 13, 17) presses the vibrating body (1) against the contact body (4).

16. The vibration type actuator (101, 102) according to claim 15, wherein the reaction force receiving portion (9) is a roller that comes into contact with the contact body (4) and rotates, in accordance with movement of the contact body, by a frictional force generated between the roller and the contact body.

17. The vibration type actuator (201-205, 301, 302) according to claim 15,
wherein the vibrating body unit (20, 26, 27, 30) includes two vibrating bodies (1) arranged with the contact body (4) interposed therebetween, and
one of the two vibrating bodies functions as the reaction force receiving portion (9).

18. The vibration type actuator (101, 102, 201-205, 301, 302) according to any one of claims 1 to 16,
wherein the vibrating body (1) includes an elastic body (2) having a protrusion (2a) in contact with the contact body (4), and an electromechanical energy conversion element (3) attached to the elastic body, and
elliptical movement is excited, in a plane including the first direction and the pressurizing direction by the pressurizing unit (7, 13, 17), at a tip of the protrusion, and the protrusion applies thrust to the contact body, so that the contact body and the vibrating body unit (5, 11, 20, 26, 27, 30, 40) move relative to each other.

19. A device (501, 502) comprising:
the vibration type actuator (101, 102, 201-205, 301, 302) according to any one of claims 1 to 18; and
a component driven by the vibration type actuator.

20. A multi-axis stage (503) comprising:
the vibration type actuator (101, 102, 201-205, 301, 302) according to any one of claims 1 to 18;
a fixing portion (41) to which the vibration type actuator is fixed; and
a stage (42, 43, 44) connected to the contact body (4) and configured to move relative to the fixing portion in a predetermined direction.

21. An articulated robot (505, 506) comprising the vibration type actuator (101, 102, 201-205, 301, 302) according to any one of claims 1 to 18 as a drive source.

## Patentansprüche

1. Aktuator vom Schwingungstyp (101, 102, 201-205, 301, 302), umfassend:
eine Schwingungskörpereinheit (5, 11, 20, 26, 27, 30, 40), die einen Schwingungskörper (1) und einen Halteabschnitt (8, 18, 28, 8h) enthält, der ausgebildet ist, den Schwingungskörper zu halten;
eine Druckbeaufschlagungseinheit (7, 13, 17);
einen Kontaktkörper (4), der durch eine Druckbeaufschlagungskraft durch die Druckbeaufschlagungseinheit mit dem Schwingungskörper in Kontakt kommt; und
einen Verbindungsabschnitt (14, 14e, 14h),
wobei, wenn eine vorbestimmte Schwingung in dem Schwingungskörper angeregt wird, sich der Kontaktkörper und die Schwingungskörpereinheit relativ zueinander in einer ersten Richtung bewegen, und
der Verbindungsabschnitt den Halteabschnitt mit einem Verbindungsobjekt in der ersten Richtung verbindet, so dass die Schwingungskörpereinheit durch die Druckbeaufschlagungseinheit zumindest in einer Druckbeaufschlagungsrichtung verschoben wird, wenn sich der Kontaktkörper und die Schwingungskörpereinheit relativ zueinander in der ersten Richtung bewegen,
**dadurch gekennzeichnet, dass** der Verbindungsabschnitt (14, 14e, 14h) einen Drehfreiheitsgrad von zwei oder mehr Freiheitsgraden aufweist und durch eine Drehwelle (14a) oder einen kugelförmigen Abschnitt (14g) mit einem Drehfreiheitsgrad von einem oder mehreren Freiheitsgraden in Bezug auf die Schwingungskörpereinheit (5, 11, 20, 26, 27, 30, 40) beschränkt ist.

2. Aktuator vom Schwingungstyp (101, 102, 201-205, 301, 302) nach Anspruch 1,
wobei der Verbindungsabschnitt (14, 14e) zwei zylindrische säulenförmige Wellenabschnitte enthält, die im Wesentlichen parallel in einem vorbestimmten Intervall angeordnet sind, und
der Halteabschnitt (8, 18, 28, 8h) Durchgangslöcher aufweist, die ausgebildet sind, einen der zwei Wellenabschnitte drehbar zu halten.

3. Aktuator vom Schwingungstyp (101, 102, 201-205, 301, 302) nach Anspruch 1,
wobei der Verbindungsabschnitt (14h) eine Struktur aufweist, in der kugelförmige Abschnitte an beiden Enden eines Wellenabschnitts vorgesehen sind, und
der Halteabschnitt (8, 18, 28, 8h) kugelförmige Löcher aufweist, die ausgebildet sind, die kugelförmigen Abschnitte drehbar zu halten.

4. Aktuator vom Schwingungstyp (101, 102, 201-205, 301, 302) nach Anspruch 1 oder 2, ferner umfassend mehrere der Schwingungskörpereinheiten (5, 11, 20, 26, 27, 30, 40),
wobei der Verbindungsabschnitt (14, 14e, 14h) die zwei Schwingungskörpereinheiten, die nebeneinander in der ersten Richtung angeordnet sind, verbindet und durch eine jeweilige der zwei Schwingungskörpereinheiten mit einem Drehfreiheitsgrad von einem Freiheitsgrad beschränkt ist.

5. Aktuator vom Schwingungstyp (201-204, 301, 302) nach Anspruch 4, ferner umfassend:
ein Stützelement (15, 35, 36), das ausgebildet ist, die mehreren Schwingungskörpereinheiten (5, 11, 20, 26, 27, 30, 40) zu stützen; und
einen Verschiebungsunterdrückungsabschnitt (21), der an dem Stützelement angebracht ist und ausgebildet ist, eine Verschiebung des Verbindungsabschnitts (14, 14e, 14h) in einer zweiten Richtung senkrecht zur ersten Richtung und der Druckbeaufschlagungsrichtung durch die Druckbeaufschlagungseinheit (7, 13, 17) zu regulieren.

6. Aktuator vom Schwingungstyp (101, 102, 201-204, 301, 302) nach Anspruch 4 oder 5, ferner umfassend Kontaktkörperstützabschnitte (12), die an einem Halteabschnitt (8, 18, 28, 8h) einer jeweiligen Schwingungskörpereinheit angebracht sind, die sich an einem jeweiligen Ende in der ersten Richtung unter den mehreren Schwingungskörpereinheiten (5, 11, 20, 26, 27, 30, 40) befindet, und ausgebildet sind, den Kontaktkörper (4) in der ersten Richtung beweglich zu stützen.

7. Aktuator vom Schwingungstyp (203, 204, 302) nach Anspruch 6, ferner umfassend:
ein Stützelement (15, 35, 36), das ausgebildet ist, die Schwingungskörpereinheit (5, 11, 20, 26, 27, 30, 40) zu stützen; und
einen ersten Beschränkungsabschnitt (31, 32), der an dem Stützelement angebracht ist und ausgebildet ist, eine Bewegung in der ersten Richtung einer Schwingungskörpereinheit zu regulieren, die sich an zumindest einem Ende in der ersten Richtung unter den mehreren Schwingungskörpereinheiten befindet.

8. Aktuator vom Schwingungstyp (203, 204, 302) nach Anspruch 7, wobei der erste Beschränkungsabschnitt (31, 32) eine Bewegung der Schwingungskörpereinheit (5, 11, 20, 26, 27, 30, 40) in einer zweiten Richtung senkrecht zur ersten Richtung und der Druckbeaufschlagungsrichtung durch die Druckbeaufschlagungseinheit (7, 13, 17) reguliert.

9. Aktuator vom Schwingungstyp (203, 204, 302) nach Anspruch 7 oder 8, ferner umfassend einen zweiten Beschränkungsabschnitt (31, 32), der an dem Stützelement (15, 35, 36) angebracht ist und ausgebildet ist, eine Verschiebung einer Schwingungskörpereinheit, die sich an einem Ende in der ersten Richtung unter den mehreren Schwingungskörpereinheiten (5, 11, 20, 26, 27, 30, 40) befindet, in der zweiten Richtung senkrecht zur ersten Richtung und der Druckbeaufschlagungsrichtung durch die Druckbeaufschlagungseinheit (7, 13, 17) zu regulieren.

10. Aktuator vom Schwingungstyp (301) nach einem der Ansprüche 5 bis 9, ferner umfassend einen Stützführungsabschnitt (29), der an einem Halteabschnitt (8, 18, 28, 8h) von zumindest einer der mehreren Schwingungskörpereinheiten (5, 11, 20, 26, 27, 30, 40) angebracht ist und ausgebildet ist, eine Verschiebung des Halteabschnitts in einer zweiten Richtung senkrecht zur ersten Richtung und der Druckbeaufschlagungsrichtung durch die Druckbeaufschlagungseinheit (7, 13, 17) und in der ersten Richtung zu regulieren.

11. Aktuator vom Schwingungstyp (205) nach Anspruch 4 oder 5, wobei zumindest zwei der mehreren Schwingungskörpereinheiten (5, 11, 20, 26, 27, 30, 40) derart angeordnet sind, dass Schwingungskörper (1) der zwei Schwingungskörpereinheiten mit dem Kontaktkörper (4) in verschiedenen Winkeln auf einer Ebene senkrecht zur ersten Richtung in Kontakt sind.

12. Aktuator vom Schwingungstyp (101, 102, 201, 202, 205, 301) nach Anspruch 1 oder 2, ferner umfassend ein Stützelement (15, 35, 36), das ausgebildet ist, die Schwingungskörpereinheit (5, 11, 20, 26, 27, 30, 40) zu stützen,
wobei der Verbindungsabschnitt (14, 14e, 14h) die Schwingungskörpereinheit und das Stützelement in einem Zustand verbindet, in dem er mit einem Drehfreiheitsgrad von einem Freiheitsgrad in Bezug auf die Schwingungskörpereinheit und das Stützelement beschränkt ist.

13. Aktuator vom Schwingungstyp (101, 102, 201, 202, 205, 301) nach Anspruch 12, ferner umfassend einen Kontaktkörperstützabschnitt (12), der an dem Stützelement (15, 35, 36) angebracht und ausgebildet ist, den Kontaktkörper (4) in der ersten Richtung beweglich zu stützen.

14. Aktuator vom Schwingungstyp (201-204, 301, 302) nach Anspruch 12 oder 13, ferner umfassend einen Verschiebungsunterdrückungsabschnitt (21), der an dem Stützelement (15, 35, 36) angebracht und ausgebildet ist, eine Verschiebung des Verbindungsabschnitts (14, 14e, 14h) in einer zweiten Richtung senkrecht zur ersten Richtung und der Druckbeaufschlagungsrichtung durch die Druckbeaufschlagungseinheit (7, 13, 17) zu regulieren.

15. Aktuator vom Schwingungstyp (101, 102) nach einem der Ansprüche 1 bis 14, wobei die Schwingungskörpereinheit (5, 11) einen Reaktionskraftaufnahmeabschnitt (9) enthält, der ausgebildet ist, eine Reaktionskraft einer Druckbeaufschlagungskraft aufzunehmen, durch die die Druckbeaufschlagungseinheit (7, 13, 17) den Schwingungskörper (1) gegen den Kontaktkörper (4) drückt.

16. Aktuator vom Schwingungstyp (101, 102) nach Anspruch 15, wobei der Reaktionskraftaufnahmeabschnitt (9) eine Rolle ist, die mit dem Kontaktkörper (4) in Kontakt kommt und sich gemäß einer Bewegung des Kontaktkörpers durch eine Reibungskraft dreht, die zwischen der Rolle und dem Kontaktkörper erzeugt wird.

17. Aktuator vom Schwingungstyp (201-205, 301, 302) nach Anspruch 15,
wobei die Schwingungskörpereinheit (20, 26, 27, 30) zwei Schwingungskörper (1) enthält, die mit dem Kontaktkörper (4) dazwischen angeordnet sind, und
einer der zwei Schwingungskörper als der Reaktionskraftaufnahmeabschnitt (9) fungiert.

18. Aktuator vom Schwingungstyp (101, 102, 201-205, 301, 302) nach einem der Ansprüche 1 bis 16,
wobei der Schwingungskörper (1) einen elastischen Körper (2) mit einem Vorsprung (2a) in Kontakt mit dem Kontaktkörper (4) und ein elektromechanisches Energieumwandlungselement (3) enthält, das an dem elastischen Körper angebracht ist, und
eine elliptische Bewegung in einer Ebene, die die erste Richtung und die Druckbeaufschlagungsrichtung enthält, durch die Druckbeaufschlagungseinheit (7, 13, 17) an einer Spitze des Vorsprungs angeregt wird und der Vorsprung einen Schub auf den Kontaktkörper ausübt, so dass sich der Kontaktkörper und die Schwingungskörpereinheit (5, 11, 20, 26, 27, 30, 40) relativ zueinander bewegen.

19. Vorrichtung (501, 502), umfassend:
den Aktuator vom Schwingungstyp (101, 102, 201-205, 301, 302) nach einem der Ansprüche 1 bis 18; und
eine Komponente, die durch den Aktuator vom Schwingungstyp angetrieben wird.

20. Mehrachsenstufe (503), umfassend:
den Aktuator vom Schwingungstyp (101, 102, 201-205, 301, 302) nach einem der Ansprüche 1 bis 18;
einen Befestigungsabschnitt (41), an dem der Aktuator vom Schwingungstyp befestigt ist; und
eine Stufe (42, 43, 44), die mit dem Kontaktkörper (4) verbunden und ausgebildet ist, sich relativ zum Befestigungsabschnitt in einer vorbestimmten Richtung zu bewegen.

21. Gelenkroboter (505, 506), umfassend den Aktuator vom Schwingungstyp (101, 102, 201-205, 301, 302) nach einem der Ansprüche 1 bis 18 als Antriebsquelle.

## Revendications

1. Actionneur de type à vibration (101, 102, 201-205, 301, 302) comprenant :
une unité de corps vibrant (5, 11, 20, 26, 27, 30, 40) comportant un corps vibrant (1) et une partie de maintien (8, 18, 28, 8h) configurée pour maintenir le corps vibrant ; une unité de pression (7, 13, 17) ;
un corps de contact (4) qui vient en contact avec le corps vibrant par une force de pression de l'unité de pression ; et
une partie de liaison (14, 14e, 14h),
dans lequel lorsqu'une vibration prédéterminée est excitée dans le corps vibrant, le corps de contact et l'unité de corps vibrant bougent l'un par rapport à l'autre dans une première direction, et
la partie de liaison relie la partie de maintien à un objet de liaison dans la première direction, de sorte que l'unité de corps vibrant soit déplacée au moins dans une direction de pression de l'unité de pression lorsque le corps de contact et l'unité de corps vibrant bougent l'un par rapport à l'autre dans la première direction,
**caractérisé en ce que** la partie de liaison (14, 14e, 14h) a un degré de liberté de rotation de deux degrés de liberté ou plus, et est restreinte par un arbre de rotation (14a) ou une partie sphérique (14g) ayant un degré de liberté de rotation d'un ou plusieurs degrés de liberté par rapport à l'unité de corps vibrant (5, 11, 20, 26, 27, 30, 40).

2. Actionneur de type à vibration (101, 102, 201-205, 301, 302) selon la revendication 1,
dans lequel la partie de liaison (14, 14e) comporte deux parties d'arbre en colonne cylindriques agencées sensiblement en parallèle à un intervalle prédéterminé, et la partie de maintien (8, 18, 28, 8h) a des trous de dégagement configurés pour maintenir de manière rotative l'une des deux parties d'arbre.

3. Actionneur de type à vibration (101, 102, 201-205, 301, 302) selon la revendication 1,
dans lequel la partie de liaison (14h) a une structure dans laquelle des parties sphériques sont prévues aux deux extrémités d'une partie d'arbre, et
la partie de maintien (8, 18, 28, 8h) a des trous sphériques configurés pour maintenir de manière rotative les parties sphériques.

4. Actionneur de type à vibration (101, 102, 201-205, 301, 302) selon la revendication 1 ou 2, comprenant en outre une pluralité des unités de corps vibrants (5, 11, 20, 26, 27, 30, 40),
dans lequel la partie de liaison (14, 14e, 14h) relie les deux unités de corps vibrants agencées côte à côte dans la première direction, et est restreinte par chacune des deux unités de corps vibrants avec un degré de liberté de rotation d'un degré de liberté.

5. Actionneur de type à vibration (201-204, 301, 302) selon la revendication 4, comprenant en outre :
un organe de support (15, 35, 36) configuré pour supporter la pluralité d'unités de corps vibrants (5, 11, 20, 26, 27, 30, 40) ; et
une partie de suppression de déplacement (21) fixée à l'organe de support et configurée pour réguler le déplacement de la partie de liaison (14, 14e, 14h) dans une deuxième direction orthogonale à la première direction et à la direction de pression de l'unité de pression (7, 13, 17).

6. Actionneur de type à vibration (101, 102, 201-204, 301, 302) selon la revendication 4 ou 5, comprenant en outre des parties de support de corps de contact (12) fixées à une partie de maintien (8, 18, 28, 8h) de chaque unité de corps de vibration située à chaque extrémité dans la première direction, parmi la pluralité d'unités de corps vibrants (5, 11, 20, 26, 27, 30, 40), et configurées pour supporter de manière mobile le corps de contact (4) dans la première direction.

7. Actionneur de type à vibration (203, 204, 302) selon la revendication 6, comprenant en outre :
un organe de support (15, 35, 36) configuré pour supporter l'unité de corps vibrant (5, 11, 20, 26, 27, 30, 40) ; et
une première partie de restriction (31, 32) fixée à l'organe de support et configurée pour réguler le mouvement dans la première direction d'une unité de corps vibrant située à au moins une extrémité dans la première direction parmi la pluralité d'unités de corps vibrants.

8. Actionneur de type à vibration (203, 204, 302) selon la revendication 7, dans lequel la première partie de restriction (31, 32) régule le mouvement de l'unité de corps vibrant (5, 11, 20, 26, 27, 30, 40) dans une deuxième direction orthogonale à la première direction et à la direction de pression de l'unité de pression (7, 13, 17).

9. Actionneur de type à vibration (203, 204, 302) selon la revendication 7 ou 8, comprenant en outre une seconde partie de restriction (31, 32) fixée à l'organe de support (15, 35, 36) et configurée pour réguler le déplacement d'une unité de corps vibrant, située à une extrémité dans la première direction parmi la pluralité d'unités de corps vibrants (5, 11, 20, 26, 27, 30, 40), dans la deuxième direction orthogonale à la première direction et à la direction de pression de l'unité de pression (7, 13, 17).

10. Actionneur de type à vibration (301) selon l'une quelconque des revendications 5 à 9, comprenant en outre une partie de guidage de support (29) fixée à une partie de maintien (8, 18, 28, 8h) d'au moins une de la pluralité d'unités de corps vibrants (5, 11, 20, 26, 27, 30, 40) et configurée pour réguler le déplacement de la partie de maintien dans une deuxième direction orthogonale à la première direction et à la direction de pression de l'unité de pression (7, 13, 17) et dans la première direction.

11. Actionneur de type à vibration (205) selon la revendication 4 ou 5, dans lequel au moins deux de la pluralité d'unités de corps vibrants (5, 11, 20, 26, 27, 30, 40) sont agencées de sorte que les corps vibrants (1) des deux unités de corps vibrants soient en contact avec le corps de contact (4) à des angles différents sur un plan orthogonal à la première direction.

12. Actionneur de type à vibration (101, 102, 201, 202, 205, 301) selon la revendication 1 ou 2, comprenant en outre un organe de support (15, 35, 36) configuré pour supporter l'unité de corps vibrant (5, 11, 20, 26, 27, 30, 40),
dans lequel la partie de liaison (14, 14e, 14h) relie l'unité de corps vibrant et l'organe de support dans un état où il est restreint avec un degré de liberté de rotation d'un degré de liberté par rapport à chacun de l'unité de corps vibrant et de l'organe de support.

13. Actionneur de type à vibration (101, 102, 201, 202, 205, 301) selon la revendication 12, comprenant en outre une partie de support de corps de contact (12) fixée à l'organe de support (15, 35, 36) et configurée pour supporter de manière mobile le corps de contact (4) dans la première direction.

14. Actionneur de type à vibration (201-204, 301, 302) selon la revendication 12 ou 13, comprenant en outre une partie de suppression de déplacement (21) fixée à l'organe de support (15, 35, 36) et configurée pour réguler le déplacement de la partie de liaison (14, 14e, 14h) dans une deuxième direction orthogonale à la première direction et à la direction de pression de l'unité de pression (7, 13, 17).

15. Actionneur de type à vibration (101, 102) selon l'une quelconque des revendications 1 à 14, dans lequel l'unité de corps vibrant (5, 11) comporte une partie de réception de force de réaction (9) configurée pour recevoir une force de réaction d'une force de pression par laquelle l'unité de pression (7, 13, 17) presse le corps vibrant (1) contre le corps de contact (4).

16. Actionneur de type à vibration (101, 102) selon la revendication 15, dans lequel la partie de réception de force de réaction (9) est un rouleau qui vient en contact avec le corps de contact (4) et tourne, conformément au mouvement du corps de contact, par une force de friction générée entre le rouleau et le corps de contact.

17. Actionneur de type à vibration (201-205, 301, 302) selon la revendication 15,
dans lequel l'unité de corps vibrant (20, 26, 27, 30) comporte deux corps vibrants (1) agencés avec le corps de contact (4) interposé entre ceux-ci, et
l'un des deux corps vibrants sert de partie de réception de force de réaction (9).

18. Actionneur de type à vibration (101, 102, 201-205, 301, 302) selon l'une quelconque des revendications 1 à 16, dans lequel le corps vibrant (1) comporte un corps élastique (2) ayant une saillie (2a) en contact avec le corps de contact (4), et un élément de conversion d'énergie électromécanique (3) fixé au corps élastique, et
le mouvement elliptique est excité, dans un plan comportant la première direction et la direction de pression de l'unité de pression (7, 13, 17), à un bout de la saillie, et la saillie applique une poussée sur le corps de contact, de telle façon que le corps de contact et l'unité de corps vibrant (5, 11, 20, 26, 27, 30, 40) bougent l'un par rapport à l'autre.

19. Dispositif (501, 502) comprenant :
l'actionneur de type à vibration (101, 102, 201-205, 301, 302) selon l'une quelconque des revendications 1 à 18 ; et un composant entraîné par l'actionneur de type à vibration.

20. Étage multiaxial (503) comprenant :
l'actionneur de type à vibration (101, 102, 201-205, 301, 302) selon l'une quelconque des revendications 1 à 18 ; une partie de fixation (41) à laquelle l'actionneur de type à vibration est fixé ; et
un étage (42, 43, 44) relié au corps de contact (4) et configuré pour bouger par rapport à la partie de fixation dans une direction prédéterminée.

21. Robot articulé (505, 506) comprenant l'actionneur de type à vibration (101, 102, 201-205, 301, 302) selon l'une quelconque des revendications 1 à 18 en tant que source d'entraînement.
